## Europäisches Patentamt
## European Patent Office
## Office européen des brevets

(19)

(11) Numéro de publication: **0 165 109**
**B1**

# (12) FASCICULE DE BREVET EUROPEEN

(45) Date de publication du fascicule du brevet:
**22.03.89**

(21) Numéro de dépôt: **85400873.7**

(22) Date de dépôt: **06.05.85**

(51) Int. Cl.⁴: **G 01 R 31/00,** G 01 R 27/26,
G 01 N 27/22

(54) Procédé et dispositif pour le test de matériaux diélectriques, en particulier de condensateurs.

(30) Priorité: **10.05.84 FR 8407196**

(43) Date de publication de la demande:
**18.12.85 Bulletin 85/51**

(45) Mention de la délivrance du brevet:
**22.03.89 Bulletin 89/12**

(84) Etats contractants désignés:
**AT BE CH DE FR GB IT LI LU NL SE**

(56) Documents cités:
**EP-A- 0 089 946**
**FR-A- 2 164 316**
**US-A- 4 330 777**

(73) Titulaire: **UNIVERSITE DE RENNES I, Campus de Beaulieu Avenue du Général Leclerc, F-35000 Rennes (FR)**

(72) Inventeur: **De Burgat, Michel, 16, rue du papier timbré, F-35100 Rennes (FR)**
Inventeur: **Le Traon, André, 18, rue des Tilleuls, F-35510 Cesson Sevigne (FR)**
Inventeur: **Pilet, Jean-Claude, 27, Boulevard Charles Péguy, F-35000 Rennes (FR)**
Inventeur: **Sharaiha, Ammar, 8, Square du Luxembourg Appt. 94, F-35000 Rennes (FR)**

(74) Mandataire: **Martin, Jean-Jacques et al, Cabinet REGIMBEAU 26, Avenue Kléber, F-75116 Paris (FR)**

## Description

La présente invention concerne un procédé et un dispositif pour le test rapide de condensateurs et de matériaux diélectriques.

Les dispositifs jusqu'ici proposés pour réaliser des tests sur des matériaux diélectriques ou des condensateurs soit n'opèrent qu'à une seule fréquence, soit s'avèrent particulièrement longs (voir par exemple FR-A-2 164 316).

La présente invention vient maintenant proposer un nouveau procédé et dispositif permettant d'obtenir rapidement la réponse en fréquence desdits matériaux diélectriques ou condensateurs sur une large gamme de fréquences, par exemple de 10 Hz à 1 MHz.

La présente invention permet ainsi un contrôle beaucoup plus complet.

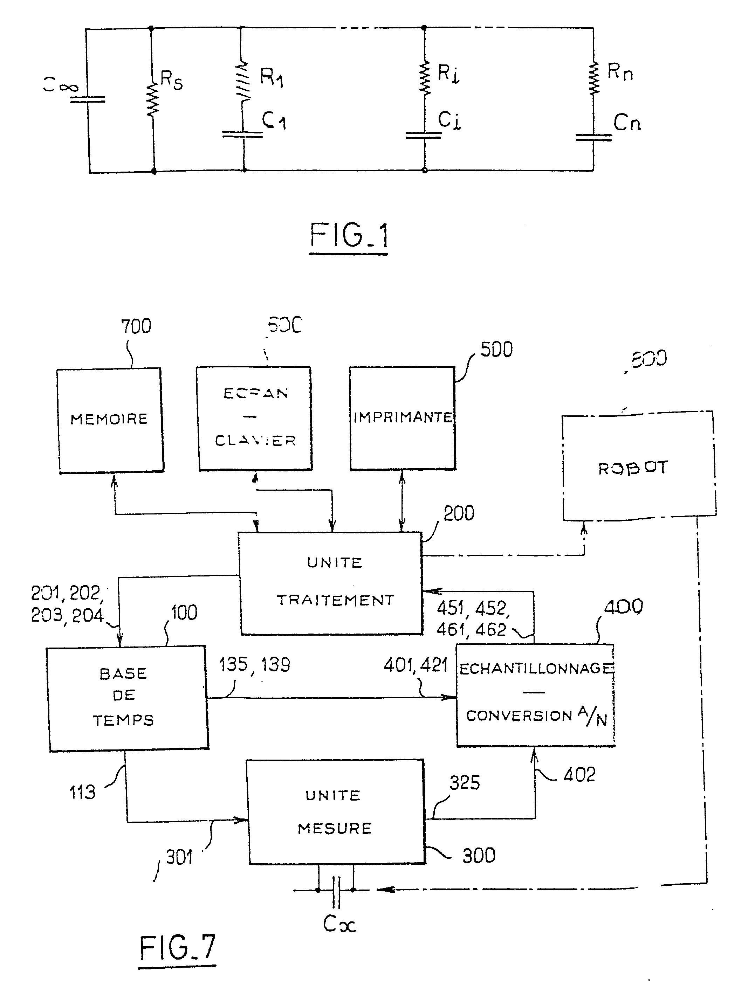

Plus précisément, la présente invention a pour but de déterminer les paramètres $R_i$, $C_i$ d'un condensateur, ou matériau diélectrique représenté par un modèle de FOSTER, tel qu'illustré sur la figure 1 annexée.

On rappelle que le théorème de FOSTER montre qu'un condensateur imparfait peut être représenté par un réseau équivalent composé d'une association de capacités et de résistances. Comme représenté sur la figure 1 annexée, ce réseau équivalent comporte, en parallèle, un certain nombre (n) de branches formées chacune d'une résistance $R_i$ et d'une capacité $C_i$, connectées en série, et en outre, deux branches particulières, également en parallèle, qui rendent compte des conditions limites, et qui comprennent l'une une capacité pure $C\infty$, l'autre une résistance pure $R_s$.

Ceci conduit, à écrire la capacité du condensateur sous la forme:

$$(1) \qquad C(t) = C_\infty + \frac{t}{R_s} + \sum_i C_i \left(1 - e^{-t/\tau_i}\right)$$

avec $\tau_i = R_i C_i$

La présente invention a par conséquent pour but de déterminer les paramètres $C\infty$, $R_s$, $R_i$ et $C_i$ précités.

Le procédé de test de matériaux diélectriques, en particulier de condensateurs, conforme à la présente invention, comprend les étapes consistant:

i) à insérer l'élément à tester en série d'une impédance de référence dans une chaîne de mesure,

ii) à appliquer à la chaîne de mesure des créneaux répétitifs de stimulation,

iii) à remettre à zéro la tension aux bornes de l'impédance de référence, au cours de chaque demi-alternance inactive des créneaux de stimulation,

iv) à échantillonner la réponse obtenue aux bornes de l'impédance de référence pour chaque créneau de stimulation, à des temps décalés progressivement par rapport aux créneaux de stimulation,

v) à analyser les échantillons pour en déduire les paramètres de l'élément testé selon un modèle de FOSTER.

Plus précisément, selon l'invention, l'impédance de référence est un condensateur qui, de préférence, possède une capacité supérieure d'environ 1000 fois à celle de l'élément à tester.

Selon une caractéristique importante de l'invention, les étapes ii) et iv) d'application de créneaux répétitifs de stimulation et d'échantillonnage sont organisées en une pluralité de salves de créneaux dont les périodes croissent d'une salve à l'autre.

Les étapes ii) et iv) précitées comprennent avantageusement successivement:

– l'application d'une première série de créneaux de stimulation de période constante, accompagnée d'une série d'impulsions d'échantillonnage de période constante et légèrement supérieure à celle des créneaux de stimulation,

– l'application d'une seconde série de créneaux de stimulation de période constante et nettement supérieure à celle des créneaux de stimulation de la première série, accompagnée d'une seconde série d'impulsions d'échantillonnage de période constante et légèrement supérieure à un sous-multiple de celle des créneaux de stimulation,

– l'application d'un créneau de stimulation unique de longue durée accompagnée d'impulsions d'échantillonnage de pas progressivement croissants.

De façon avantageuse, la période des créneaux de stimulation de la première série est de l'ordre de 200 μs, la période des créneaux de stimulation de la seconde série est de l'ordre de 2 ms et le dernier créneau de stimulation présente une durée supérieure à 700 ms.

Selon une autre caractéristique avantageuse de l'invention, l'étape v) d'analyse comprend

va) la détermination de la pente finale de la réponse comme étant représentative du paramètre $1/R_s$ du modèle de FOSTER et

vb) la détermination de la valeur initiale asymptotique de la réponse comme étant représentative du paramètre $C_s$ du modèle de FOSTER, $C_s = C\infty + \sum_i C_i$.

Plus précisément, de façon avantageuse, selon l'invention, l'étape va) consiste à comparer la pente de la réponse à différents instants et à retenir comme pente finale la valeur de pente reconnue identique pour plusieurs instants, et l'étape vb) consiste à déterminer la valeur initiale asymptotique en soustrayant de la valeur du $n^{ème}$ échantillon le produit de la pente finale et de l'abscisse du $n^{ème}$ échantillon.

Selon une autre caractéristique avantageuse de l'invention, l'étape v) comprend

vc) la détermination de la valeur initiale de la réponse comme étant représentative du paramètre $C\infty$ du modèle de FOSTER.

Plus précisément, de façon avantageuse, selon l'invention, l'étape vc) consiste à déterminer la valeur initiale de la réponse par extrapolation à partir des deuxième et troisième échantillons en considérant l'origine moyenne to des temps comme étant égale à:

$$(2) \qquad to = t_2 - \frac{3\delta T}{2},$$

relation dans laquelle

$t_2$ représente l'instant d'acquisition du second échantillon et

$\delta T$ représente le pas d'échantillonnage.

Selon une autre caractéristique avantageuse de l'invention, l'étape v) comprend

vd) la détermination de l'amplitude des paliers de la courbe de la pente de la réponse comme étant représentative du paramètre $1/Ri$ du modèle de FOSTER et

ve) la détermination des abscisses des maximum de la dérivée de la pente de la réponse comme étant représentative du temps de relaxation des différentes branches R–C du modèle de FOSTER.

Selon une autre caractéristique avantageuse de l'invention, l'étape v) d'analyse comprend l'étape de conversion des paramètres $y(t)$ déterminés sur la base des échantillons pour obtenir les paramètres de la capacité, selon la loi d'étalonnage linéaire:

$C(t) = K [y(t) + a]$, dans lesquels K et a sont des constantes.

De façon préférentielle, selon l'invention, le procédé de test comprend l'étape préliminaire consistant

– à disposer deux condensateurs étalons $Cr_1$ et $Cr_2$ en série dans la chaîne de mesure,

– à détecter la réponse $v'(t)$ à un échelon de stimulation d'amplitude V appliqué à la chaîne de mesure, telle que

$$(3) \qquad v' = \frac{VG\, CR_1}{Cr_2} - a'$$

relation dans laquelle

G représente le gain du système, et

$a'$ représente une constante additive due à la remise à zéro de la chaîne de mesure, et la phase v) de traitement comprend en outre l'étape consistant

– à corriger les valeurs mesurées $y(t)$ sur la base des coefficients G et a pour obtenir les paramètres de la capacité $C(t)$ selon le modèle de FOSTER répondant à la relation:

$$(4) \qquad C(t) = K (y(t) + a)$$

De préférence, le procédé de test comprend en outre l'étape ultérieure de classement des éléments testés sur la base des paramètres déterminés à l'aide des échantillons.

De façon avantageuse, le procédé de test comprend en outre les étapes consistant à prélever un échantillon de référence $Y_{nr}$ pour chaque créneau à un instant r constant de ces créneaux et à corriger avant l'étape v) d'analyse chaque échantillon $Y_{nm}$ sur la base de la relation

$$(5) \qquad Y'_{nm} = Y_{nm} - (Y_{nr} - Y_{1r})$$

dans laquelle

$Y_{nr}$ représente l'échantillon de référence pris au $n^{ème}$ créneau et

$Y_{1r}$ représente l'échantillon de référence pris lors du premier créneau.

Le dispositif de test de matériau diélectrique, en particulier de condensateur, conforme à la présente invention comprend:

– une unité de mesure apte à recevoir l'élément à tester en série d'une impédance de référence dans une chaîne de mesure,

– une base de temps apte à appliquer à la chaîne de mesure des créneaux répétitifs de stimulation

– des moyens adaptés pour remettre à zéro la tension aux bornes de l'impédance de référence au cours de chaque demi-alternance inactive des créneaux de stimulation,

– une unité d'échantillonnage sensible à la réponse obtenue aux bornes de l'impédance de référence pour chaque créneau de stimulation, et qui échantillonne cette réponse à des temps décalés progressivement par rapport aux créneaux de stimulation,

– une unité de traitement qui analyse les échantillons établis par l'unité d'échantillonnage pour en déduire les paramètres de l'élément testé, selon un modèle de FOSTER.

De préférence, l'impédance de référence est un condensateur de référence qui possède une capacité supérieure d'environ 1000 fois à celle de l'élément à tester.

Selon une caractéristique avantageuse de l'invention, l'unité de mesure possède des moyens permettant de modifier l'impédance de référence insérée dans la chaîne de mesure.

Selon une autre caractéristique avantageuse de l'invention, l'unité d'échantillonnage comprend un convertisseur analogique/numérique.

De préférence, l'unité de traitement contrôle la base de temps de telle sorte que celle-ci génère plusieurs salves successives de créneaux de stimulation dont les périodes croissent d'une salve à l'autre.

Plus précisément, de façon préférentielle, la base de temps génère successivement

– une première série de créneaux de stimulation de période constante, accompagnée d'une série d'impulsions d'échantillonnage de période constante et légèrement supérieure à celle des créneaux de stimulation,

– une seconde série de créneaux de stimulation de période constante et nettement supérieure à celle des créneaux de stimulation de la première série, accompagnée d'une seconde série d'impulsions d'échantillonnage de période constante et légèrement supérieure à un sous-multiple de celle des créneaux de stimulation, puis

– un créneau de stimulation unique de longue durée accompagnée d'impulsions d'échantillonnage de pas progressivement croissants.

Plus précisément encore, de façon avantageuse, la période des créneaux de stimulation de la première série est de l'ordre de 200 µs, la période des créneaux de stimulation de la seconde série est de l'ordre de 2 ms et le dernier créneau de stimulation présente une durée supérieure à 700 ms.

Selon une autre caractéristique avantageuse de la présente invention, la base de temps comprend:
- une horloge,
- plusieurs diviseurs de fréquence attaqués par l'horloge et déterminant des créneaux de stimulation de périodes respectives,
- des portes de type ET connectées en sortie des diviseurs et validées alternativement par l'unité de traitement,
- une porte de type OU dont les entrées sont reliées respectivement en sortie des portes de type ET, et à la sortie de laquelle sont disponibles les créneaux de stimulation.

Selon une autre caractéristique avantageuse de l'invention, la base de temps comprend:
- une seconde série de diviseurs de fréquence attaqués par l'horloge et déterminant des impulsions d'échantillonnage de périodes respectives,
- une seconde série de portes de type ET connectées respectivement en sortie des diviseurs de fréquence de la seconde série et qui sont validées alternativement par l'unité de traitement en synchronisme avec l'une associée des portes ET de la première série, et
- une seconde porte de type OU dont les entrées sont reliées respectivement en sortie des portes ET de la deuxième série et à la sortie de laquelle sont disponibles les impulsions d'échantillonnage.

Selon l'invention, de préférence, la base de temps génère par ailleurs des impulsions d'échantillonnage auxiliaires, à un instant constant de chaque créneau de stimulation, pour le prélèvement d'échantillons de référence.

Selon une autre caractéristique préférentielle de l'invention, l'unité de mesure comprend entre la chaîne de mesure et l'unité d'échantillonnage, successivement, un étage de découplage à impédance d'entrée très élevée et au moins un étage d'amplification.

De préférence, de plus, la liaison entre la chaîne de mesure et l'étage de découplage est blindée.

Selon une autre caractéristique de l'invention, les moyens de remise à zéro de la tension aux bornes de l'impédance de référence possèdent une impédance de sortie très élevée.

Selon un mode de réalisation avantageux, les moyens de remise à zéro comprennent un transistor à effet de champ.

Selon une autre caractéristique avantageuse de l'invention, l'unité d'échantillonnage comprend en cascade un échantillonneur bloqueur, un étage amplificateur et un convertisseur analogique/numérique.

D'autres caractéristiques et avantages de la présente invention apparaîtront à la lecture de la description détaillée qui va suivre, donnée à titre d'exemples non limitatifs, et en regard des dessins annexés, sur lesquels, la figure 1 qui représente un modèle de FOSTER, ayant déjà été décrite:
- la figure 2 représente schématiquement la chaîne de mesure utilisée dans un dispositif conforme à la présente invention,

- la figure 3 représente la courbe de réponse à un échelon de stimulation,
- la figure 4 représente la pente de la courbe de réponse,
- la figure 5 représente la dérivée de la pente de la courbe de réponse,
- la figure 6a illustre schématiquement un cycle de test comprenant différentes salves de créneaux de stimulation et d'impulsions d'échantillonnage,
- la figure 6b illustre schématiquement les créneaux de stimulation, la réponse et les impulsions d'échantillonnage de la première salve,
- la figure 6c illustre les créneaux de stimulation, la réponse et les impulsions d'échantillonnage de la deuxième salve,
- la figure 7 représente schématiquement la structure générale du dispositif de test conforme à la présente invention,
- la figure 8 représente la structure de la base de temps intégrée au dispositif de test conforme à la présente invention,
- la figure 9 illustre la forme des signaux considérés en différents points de la base de temps du dispositif de la présente invention,
- la figure 10 représente la structure de l'unité de mesure intégrée au dispositif conforme à la présente invention,
- la figure 11 représente la structure de l'unité d'échantillonnage – conversion analogique/numérique intégrée au dispositif de test conforme à la présente invention,
- la figure 12 illustre schématiquement le processus de traitement des échantillons,
- la figure 13 illustre le processus d'acquisition de la première gamme d'échantillons,
- la figure 14 illustre schématiquement le processus d'acquisition de la seconde gamme d'échantillons,
- la figure 15 illustre le processus de traitement proprement dit des échantillons.

La description détaillée qui va suivre concernera le test d'un condensateur. Cette description, ainsi que les dessins s'y rapportant ne doivent en aucune façon être considérés comme limitatifs. En effet, l'invention, d'une façon générale, s'applique aux tests de matériaux diélectriques.

On va décrire successivement, par la suite, 1. le principe de la mesure, 2. la structure générale du dispositif, 3. la structure de la base de temps, 4. la structure de l'unité de mesure, 5. la structure de l'unité d'échantillonnage-conversion analogique/numérique et 6. la fonction et la structure de l'unité de traitement.

PRINCIPE DE LA MESURE

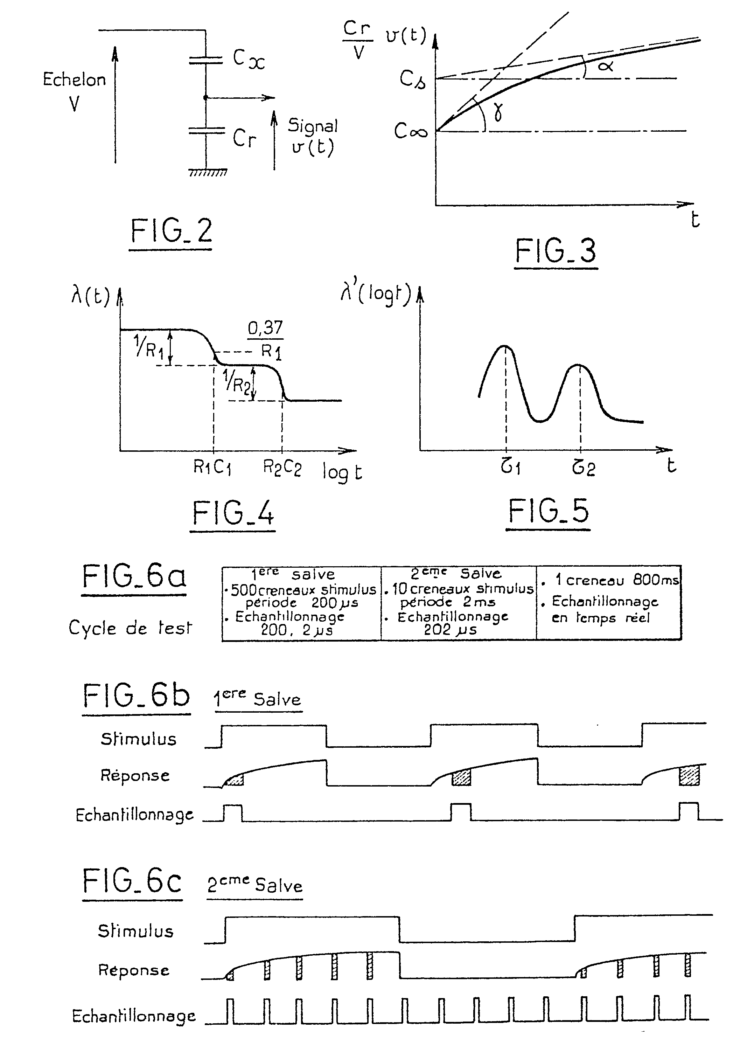

Comme cela est illustré sur la figure 2, le principe à la base de l'invention consiste à appliquer un échelon de tension V à une chaîne de mesure comportant le condensateur Cx à mesurer connecté en série avec un condensateur de référence Cr, ce dernier étant choisi de telle sorte que Cx << Cr.

On démontre alors que, en utilisant la notation de Laplace:

$$(6) \quad v(p) = \frac{V}{p} \cdot \frac{Cx(p)}{Cr + Cx(p)} \simeq \frac{V.Cx(p)}{p.Cr}, \text{ soit}$$

$$(7) \quad v(p) = \frac{V}{Cr} \left[ \frac{C_\infty}{p} + \frac{1}{Rsp} 2 + \sum_{i=1}^{n} \frac{Ci}{(1+RiCip)p} \right],$$

et donc

$$(8) \quad v(t) = \frac{V}{Cr} \left[ C_\infty + \frac{t}{Rs} + \sum_{i=1}^{n} Ci\,(1 - e^{-t/RiCi}) \right]$$

Dans le cas d'un domaine de dispersion unique, c'est-à-dire le cas où $n = 1$, les paramètres du circuit équivalent peuvent être obtenus très facilement.

En effet, comme cela est représenté sur la figure 3, les valeurs $C\infty$ et $Cs$,

$$(Cs = C_\infty + \sum_{i=1}^{n} Ci),$$

sont accessibles sans difficulté en tant que valeur initiale et valeur asymptotique de la courbe $\frac{Cr}{V} v(t)$.

Le terme de conductivité $1/Rs$ est déterminé par analyse de la pente $\alpha$ de l'asymptote, $tg\alpha = 1/Rs$. La conductance $1/R_1$ est déterminé par analyse de la pente $\gamma$ à l'origine, en effet $tg\gamma = 1/Rs + 1/R_1$, tandis que le temps de relaxation $\tau = R_1C_1$ est déterminé par l'intersection de la pente initiale et de l'asymptote à la courbe.

Dans le cas de plusieurs domaines ($n > 1$), l'analyse de la pente, représentée sur la figure 4,

$$(9) \quad \lambda(t) = \frac{\delta}{\delta t} \left[ \frac{Cr.v(t)}{V} - \frac{t}{Rs} \right] = \sum_{i=1}^{n} \frac{1}{Ri} e^{-t/\tau i}$$

permet d'obtenir les valeurs $1/Ri$.

Ces valeurs $1/Ri$ sont en effet égales aux largeurs des paliers de la courbe de pente $\lambda(t)$, comme représenté sur la figure 4.

L'analyse de cette courbe permet également d'accéder aux termes $RiCi = \tau i$ qui correspondent pour chaque palier à l'abscisse de l'ordonnée $0,37/Ri$.

Par ailleurs, l'analyse de la dérivée seconde $\lambda'(t)$ représentée sur la figure 5 permet de connaître le nombre de domaines de relaxation (correspondant au nombre de maximum) ainsi que les valeurs $\tau i$ précitées (correspondant aux abscisses desdits maximum).

Pour couvrir un domaine fréquentiel de test allant de 10 Hz à 1 MHz, en tenant compte du théorème d'échantillonnage de SHANNON d'une part et de l'influence des fréquences supérieures à la borne limite arbitraire supérieure considérée $F_M = 10$ MHz, on prend une période d'échantillonnage $T_o \simeq 1/2\pi F_M$, soit $T_o = 0,2$ µs.

Cependant, les composants classiques réalisant une conversion analogique/numérique sur 10 bits exigent un temps de conversion de l'ordre de 25 µs et exigeraient par conséquent, en théorie, une période d'échantillonnage au moins égale à 25 µs, incompatible avec la période 0,2 µs, ci-dessus déterminée.

Pour contourner cette difficulté, selon une caractéristique importante de la présente invention, la Demanderesse propose de remplacer l'échelon de stimulation par un créneau périodique, en ramenant à zéro les conditions initiales du condensateur sous test avant chaque front montant du créneau, de façon à obtenir une répétition périodique du début de la réponse à l'échelon.

Plus précisément, selon l'invention, on applique sur la chaîne de mesure un créneau périodique de période T et de rapport cyclique 1/2 et l'on échantillonne la réponse avec une période $T + \delta T$, supérieure à la période du créneau d'excitation, avec $\delta T = 0,2$ µs. La remise à zéro du condensateur sous test est effectuée lors du niveau bas du signal rectangulaire d'excitation de rapport cyclique 1/2.

L'écart $\delta T$ entre la période d'échantillonnage et la période de stimulation décale la position relative de l'échantillon $n + i$ pris dans le créneau $n + i$ par rapport à celle de l'échantillon $n$ dans le créneau $n$.

Ainsi, on réalise une transposition de temps et on dispose pour chaque échantillon équivalent à une durée $\delta T = 0,2$ µs d'un temps T important, qui peut être largement supérieur à 25 µs, pour la conversion analogique numérique.

La remise à zéro du condensateur sous test Cx est réalisée en court-circuitant à la masse le condensateur de référence Cr connecté en série de ce dernier, de telle sorte que les deux extrémités du condensateur sous test soient au potentiel zéro.

La Demanderesse a remarqué cependant que la différence de potentiel aux bornes des capacités Ci intégrées à une branche série Ci-Ri du modèle de FOSTER ne pouvait être annulée pendant la demi-alternance de niveau bas du créneau de stimulation que lorsque la constante de temps $\tau i = Ri\,Ci$ est petite devant le temps $\theta$ de remise à zéro.

Dans le cas contraire, le signal obtenu est perturbé.

Dans le cas où le temps $\theta$ de remise à zéro égale la demi-période d'échantillonnage $T/2$:

– quand $\tau i \simeq T/2$, la réponse obtenue restitue la réponse à l'échelon avec un coefficient $1/1 + e^{-T/2\tau}$ près,

– quand $\tau i >> T/2$, aucune composante n'est introduite par la branche correspondante dans le signal global.

Cependant, dans la pratique, pour des raisons technologiques, il convient d'éviter la simultanéité de l'application du stimulus et de la disparition de la remise à zéro. En d'autres termes, le temps de remise à zéro $\theta$ du condensateur sous test Cx sera inférieur, dans la pratique, à la demi-période $T/2$ du créneau de stimulation.

Cela altère également la réponse obtenue, et il en résulte que, en appelant $\Delta T$ l'écart entre le temps de remise à zéro et la demi-période de stimulation: $\theta = T/2 - \Delta T$:

– pour $\tau >> T/2$, la réponse donnée par le même créneau peut être exprimée par la relation

$$(10) \quad v_n(t') = -\frac{VC}{Cr} \cdot \frac{\Delta T}{\tau} \left[ 1 - \sum_{h=0}^{2n} \left( -e^{-T/2\tau} \right)^h \right]$$

avec $h = 2n - k$ et $k = 2n$ pour les valeurs paires et $k = 2n + 1$ pour les valeurs impaires tandis que $t' = T - nT$; les réponses sont par conséquent des paliers constants.

– pour $\tau \simeq T/2$, le régime permanent est atteint en 1 ou 2 périodes et la réponse donnée par le $n^{\text{ème}}$ créneau peut être exprimée par la relation:

$$(11) \quad v_n(t') = \frac{V}{Cr}$$

$$C \left[ \frac{1}{1+e^{-T/2\tau}} (1 - e^{-t'/2\tau}) - \frac{e^{-T/2\tau}}{1+e^{-T/2\tau}} \frac{\Delta T}{\tau} \right]$$

En comparant les relations précitées à la réponse à l'échelon:

$$(12) \quad v(t') = \frac{V}{Cr} C(1 - e^{-t'/2\tau}) \quad \text{on en déduit que}$$

– avec un temps de remise à zéro $\theta$ égal à la demi-période de stimulation, la réponse répétitive à chaque créneau est identique au début de la réponse à l'échelon, jusqu'à la fin de la durée du créneau, à un facteur près égal à

$$\frac{1}{1+e^{-T/2\tau i}}$$

dont il faut tenir compte pour déterminer Ci (ce facteur de correction est égal à l'unité pour des temps $\tau i << T$),

– avec un temps de remise à zéro $\theta$ inférieur à la demi-période de stimulation, les conclusions précédentes restent valables, si l'on annule ou compense le palier, constant pendant un créneau, et, en régime transitoire, variable d'un créneau à l'autre, qui résulte de l'existence de $\Delta T$. Ce palier égale

$$\frac{VC}{Cr} \cdot \frac{e^{-T/2\tau}}{1+e^{-T/2\tau}} \frac{\Delta T}{\tau} \quad \text{pour } \tau \simeq T/2 \text{ (relation (11))}.$$

Par ailleurs, la Demanderesse a déterminé que les informations utiles du signal sont une fonction logarithmique du temps. Ceci conduit à prendre une densité des échantillons importante pour les temps courts de la réponse temporelle (associés aux hautes fréquences de la réponse harmonique), une densité moins forte pour les temps moyens et plus lâche pour les temps longs (associées aux basses fréquences de la réponse harmonique), et donc à organiser la stimulation et l'échantillonnage en plusieurs gammes, telles que par exemple, en trois gammes, comme représentées schématiquement sur la figure 6a.

La première gamme peut être formée par exemple d'une salve de 500 créneaux de stimulus de période de 200 µs avec des signaux d'échantillonnage de la réponse d'une période de 200,2 µs constituant un vernier temporel par rapport à la stimulation. Cette gamme d'une durée réelle de 100 ms permet d'analyser des temps d'échantillonnage de 0,2 µs à 100 µs avec une période de 0,2 µs, couvrant ainsi l'équivalent d'une réponse fréquentielle de 1 MHz.

Un seul échantillon est prélevé par période de stimulation comme illustré sur la figure 6b et on dispose des 200 µs de cette période pour opérer l'échantillonnage et la conversion numérique.

La deuxième gamme peut être formée par exemple de 10 créneaux de stimulation de période de 2 ms avec des impulsions d'échantillonnage de période 202 µs. Cette gamme d'une durée réelle de 20 ms permet d'analyser des temps d'échantillonnage allant jusqu'à 1 ms avec un pas d'échantillonnage équivalent de 20 µs.

Dans ce cas, 10 échantillons sont déterminés par période de stimulation dont cinq seulement sont utiles et correspondent à la demi-alternance de niveau haut de l'impulsion de stimulation. Là encore, on dispose d'un temps de conversion de l'ordre de 200 µs. Cette disposition est illustrée sur la figure 6c.

Enfin, la troisième gamme est composée d'un créneau unique dont la durée est par exemple de 800 ms avec un échantillonnage en temps réel de pas serré jusqu'à 32 ms, et de pas plus lâches pour le reste du temps.

Les algorithmes permettant de déterminer les paramètres du condensateur $C\infty$, Rs, Ri, Ci, seront précisés ultérieurement.

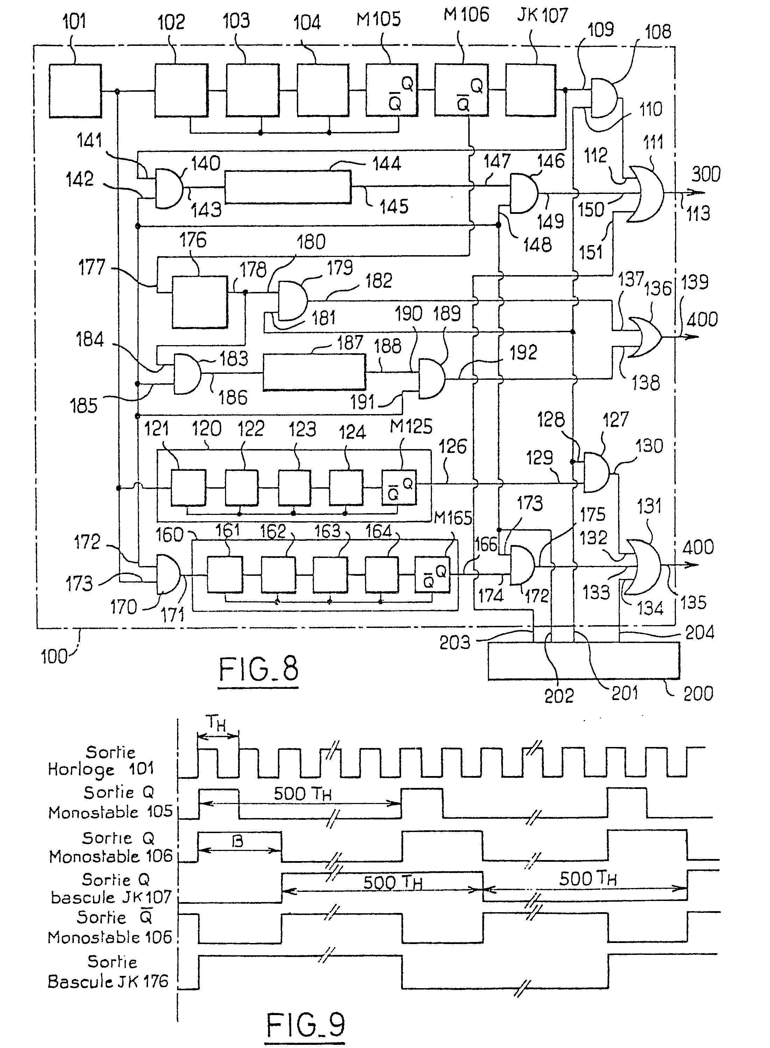

On va maintenant décrire la structure du dispositif représenté sur les figures 7 à 15.

STRUCTURE GENERALE DU DISPOSITIF

Comme cela est représenté sur la figure 7, le dispositif conforme à la présente invention comprend une base de temps 100, contrôlée par une unité de traitement 200. La base de temps 100 attaque d'une part une unité de mesure 300 recevant le condensateur Cx à tester, d'autre part une unité 400 reliée à l'unité de mesure 300, qui est sensible à la réponse du condensateur au créneau périodique et qui réalise l'échantillonnage et une conversion analogique/numérique du signal, ce dernier étant ensuite appliqué à l'unité de traitement précitée 200, qui détermine alors lesdits paramètres $C\infty$, Rs, Ci et Ri.

La fonction et la structure de chacun de ces quatre blocs fonctionnels élémentaires 100, 200, 300 et 400 seront décrits plus en détail par la suite.

On remarquera cependant dès à présent que l'unité de traitement 200 assure, outre le contrôle du séquencement des différentes salves de créneaux générés par la base de temps 100 et les tâches de traitement proprement dite, des relations avec des périphériques conventionnels, tels que imprimante 500, écran de visualisation ou clavier 600 et mémoire annexe 700, et le cas échéant avec un robot d'exploitation 800.

Les relations avec les périphériques conventionnels 500, 600, 700, assure la sortie des informations et l'entrée des consignes d'exploitation.

Le robot 800 peut être utilisé pour assurer l'insertion automatique des condensateurs Cx dans la chaîne de mesure intégrée à l'unité 300, et une évacuation desdits condensateurs, avec classement, sur la base d'une exploitation des informations de sortie.

BASE DE TEMPS –100 –

La base de temps 100 a pour fonction essentielle de générer les créneaux d'excitation et les impulsions d'échantillonnage.

Plus précisément, la base de temps 100 a pour but de générer plusieurs gammes de périodes de créneaux d'excitation accompagnés d'impulsions d'échantillonnage progressivement décalées par rapport au temps successifs d'application du stimulus ainsi que l'introduction de retards fixes, pour permettre l'observation sûre du début de la réponse. Les temps d'échantillonnage doivent respecter constamment le temps minimal de conversion analogique/digital.

Comme cela est représenté schématiquement sur la figure 8, l'unité de traitement applique des signaux de séquencement sur la base de temps 100.

Lors de la mise sous tension et au début de chaque cycle de mesure, l'unité de traitement 200 assure la remise à zéro générale du dispositif. Pour simplifier la représentation les entrées de remise à zéro des composants de la base de temps 100 n'ont pas été représentées sur la figure 8.

Dans un premier temps, l'unité de traitement 200 génère sur sa sortie 201 un signal de validation de la première gamme de créneaux d'excitation et d'échantillonnage. Une première série de données est acquise par échantillonnage et conversion du signal présent à la sortie de l'unité de mesure 300. L'unité de traitement 200 compte le nombre de données acquises.

Lorsqu'un nombre prédéterminé de données est obtenu, la sortie 201 est invalidée et l'unité de traitement génère sur sa sortie 202 un signal de validation de la seconde gamme de créneaux d'excitation et d'impulsions d'échantillonnage. Une seconde série de données est alors acquise.

Là encore, lorsqu'un nombre prédéterminé de données est obtenu au cours de cette seconde acquisition, la sortie 202 est invalidée et l'unité de traitement génère sur sa sortie 203 un créneau de 800 ms et un signal d'échantillonnage de période par exemple égale à 160 µs.

Les différentes périodes des créneaux d'excitation et des impulsions d'échantillonnage des première et seconde salves sont déterminées par divisions de la fréquence d'une horloge 101.

Cette dernière pourra être composée par exemple d'un oscillateur à portes logiques pilotées par un quartz de fréquence 5 MHz.

La première salve de créneaux d'excitation est obtenue en divisant la fréquence de l'horloge par 1000 ce qui conduit à des créneaux de période 200 µs, tandis que les impulsions d'échantillonnage sont obtenues en divisant la fréquence de l'horloge par 1001 ce qui conduit à des impulsions de période de 200,2 µs.

Comme représenté sur la figure 8, la fréquence de l'horloge 101 est divisée par 500 grâce à trois compteurs 102, 103, 104, connectés en cascade, qui assurent respectivement une division par 10, 10 et 5 et qui attaquent (compteur 104) un monostable M105 qui contrôle les compteurs 102, 103 et 104 par sa sortie $\overline{Q}$. Plus précisément, le monostable M105 commande par sa sortie $\overline{Q}$ le comptage, en absence d'un signal de remise à zéro sur les compteurs 102, 103 et 104.

La sortie Q du monostable M105 commande par le front montant un monostable M106 qui possède une durée d'impulsion β, comme représenté sur les deuxième et troisième lignes du chronogramme de la figure 9 dont la première ligne représente schématiquement le signal en sortie de l'horloge 101.

La sortie Q du monostable M106 attaque une bascule JK107 qui change d'état à chaque front descendant du signal à la sortie Q du monostable M106, comme représenté sur la quatrième ligne de la figure 9. La sortie de cette bascule JK107 est reliée à la première borne 109 d'une porte ET 108 qui reçoit sur sa seconde borne 110 le signal de validation de la première salve (sortie 201 de l'unité de traitement 200). La sortie de la porte ET 108 est reliée à la première borne 112 d'une porte OU 111. On remarquera que la bascule JK107 assure une division par deux de la fréquence du signal en sortie du monostable M106.

La sortie 113 de la porte OU 111, sur laquelle sont disponibles les créneaux d'excitation est reliée à l'unité de mesure 300.

Le retard β introduit par le monostable M106 par rapport à l'origine des temps, a pour but de compenser le retard apporté par l'échantillonneur-bloqueur intégré à l'unité 400. Cette disposition sera explicitée par la suite.

Cependant, selon l'invention, ledit retard β introduit par le monostable M106 est choisi supérieur à la durée minimale de l'impulsion d'échantillonnage, de telle sorte que l'on obtienne quelques échantillons de valeur nulle pris pendant le niveau bas du créneau de stimulation correspondant à la phase de remise à zéro. Cette disposition permet de repérer clairement le premier échantillon réel qui est en fait le premier échantillon non nul.

Comme cela ressort de la description qui précède et de l'examen des figures 8 et 9, on obtient ainsi à la sortie de la bascule JK107 (4ème ligne de la figure 9) des créneaux de période 200 µs et de rapport cyclique 1/2. Ces créneaux sont retardés d'une durée β par rapport à l'origine des temps.

Les signaux présents à la sortie de la bascule JK107 se retrouvent à la sortie 113 de la porte OU 111 lorsque la porte ET 108 est validée, c'est-à-dire lorsqu'un signal de niveau haut est appliqué sur l'entrée 110 de celle-ci par la sortie 201 de l'unité de traitement.

Comme cela a été précédemment évoqué, les impulsions d'échantillonnage sont obtenues en divisant la fréquence de l'horloge 101 par 1001 pour obtenir des impulsions de période 200,2 µs.

Cette division par 1001 est opérée par l'élément référencé 120 sur la figure 8.

Dans la pratique, cet élément 120 pourra être constitué de quatre compteurs 121, 122, 123 et 124 capables d'effectuer un comptage de N à 9 avec $0 < N < 9$ et prépositionnés à 8999. La chaîne de comptage 121-122-123 et 124 attaque un monostable M125 qui par sa sortie $\bar{Q}$ commande le comptage en absence d'un signal de remise à zéro sur les compteurs 121, 122, 123 et 124.

La sortie $\bar{Q}$ du monostable M125 sera validée lorsque le comptage aura atteint 10 000, ce qui de 8999 à 10 000 conduit bien à une division par 1001.

La sortie Q, référencée 126 du monostable 125, qui constitue la sortie de l'élément 120, est reliée à la première borne 129 d'une porte ET 127, qui reçoit sur sa seconde borne 128 le signal de validation de la première salve issue de la sortie 201 de l'unité de traitement 200.

La sortie 130 de la porte ET 127 est reliée à la première borne 132 d'une porte OU 131 à trois entrées dont la sortie 135 est reliée à l'unité d'échantillonnage et de conversion analogique/numérique 400.

Comme cela ressort de la description qui précède, on obtient à la sortie 126 du monostable 125 des impulsions de période 200,2 µs qui se décalent donc progressivement par rapport aux créneaux de stimulation.

Les signaux présents à la sortie 126 du monostable 125 se retrouvent à la sortie 135 de la porte OU 131 lorsque la porte ET 127 est validée, c'est-à-dire lorsqu'un signal de niveau haut est appliqué sur l'entrée 128 de celle-ci par la sortie 201 de l'unité de traitement.

La seconde salve de créneaux d'excitation est obtenue en divisant par 10 la fréquence des créneaux d'excitation de la première gamme, ce qui conduit à des créneaux de stimulation de périodes de 2 ms, tandis que les impulsions d'échantillonnage de la seconde salve sont obtenues en divisant la fréquence de l'horloge par 1010, ce qui conduit à des impulsions de périodes 202 µs.

On rappelle que au cours de cette seconde salve, on prélève non plus un échantillon mais cinq échantillons utiles par période de créneaux d'excitation, avec un pas équivalent de 20 µs.

Comme cela est représenté sur la figure 8, la sortie de la bascule JK107 est reliée à la première borne 141 d'une porte ET 140 à deux entrées, qui reçoit sur sa seconde borne 142 le signal de validation de la seconde salve (sortie 202 de l'unité de traitement 200). La sortie 143 de la porte ET 140 est reliée à l'entrée d'un organe 144 assurant une division par 10 de la fréquence du signal présent à la sortie de la bascule JK107.

La sortie 145 de l'organe 144 est reliée à la première borne 147 d'une porte 146 du type ET, à deux entrées, qui reçoit sur sa seconde borne d'entrée 148 le signal de validation de la seconde salve (sortie 202 de l'unité de traitement 200). La sortie 149 de la porte ET 146 est reliée à la seconde borne d'entrée 150 de la porte OU 111 précitée.

Comme cela ressort de la description qui précède et de l'examen de la figure 8, on obtient ainsi à la sortie de l'organe 144 des créneaux de périodes de 2 ms et de rapport cyclique 1/2. Ces créneaux sont retardés d'une durée ε par rapport à l'origine des temps. Ce retard est introduit par le monostable 106 précité intercalé entre l'horloge 101 et l'organe diviseur 144.

Les signaux présents à la sortie de l'organe diviseur 144 se retrouvent à la sortie 113 de la porte OU 111 lorsque la porte ET 146 est validée, c'est-à-dire lorsqu'un signal de niveau haut est appliqué sur l'entrée 148 de celle-ci par la sortie 202 de l'unité de traitement 200.

Comme cela a été précédemment évoqué, les impulsions d'échantillonnage accompagnant cette seconde salve sont obtenues en divisant la fréquence de l'horloge 101 par 1010 pour obtenir des impulsions de période 202 µs.

Cette division par 1010 est opérée par l'élément référencé 160 sur la figure 8.

Dans la pratique, cet élément 160 pourra être constitué, de façon similaire à l'élément 120 précité de quatre compteurs 161, 162, 163 et 164 capables d'effectuer un comptage de N à 9, avec $0 < N < 9$ et prépositionnés à 8990. La chaîne de comptage 161-162-163 et 164 attaque un monostable M165 qui, par sa sortie $\bar{Q}$ commande le comptage des compteurs précités 161, 162, 163 et 164 en l'absence de signal de remise à zéro sur ceux-ci.

Par ailleurs, l'entrée du premier compteur 161 de l'élément 160 est relié à la sortie 171 d'une porte ET 170 à deux entrées. Les entrées 172 et 173 de cette porte 170 sont reliées respectivement à la sortie de l'horloge 101 et à la sortie 202 de l'unité de traitement 200 validant la seconde gamme.

La sortie $\bar{Q}$ du monostable 165 sera validée lorsque le comptage de l'élément 160 aura atteint 10 000, ce qui de 8990 à 10 000 conduit bien à une division par 1010.

La sortie Q, référencée 166 du monostable M165, qui constitue la sortie de l'élément diviseur 160, est reliée à la première borne 174 d'une porte ET 172 à deux entrées qui reçoit sur sa seconde borne 173 le signal de validation de la seconde salve issue de la sortie 202 de l'unité de traitement 200. La sortie 175 de la porte ET 172 est reliée à la seconde borne 133 de la porte OU 131 précitée à trois entrées, dont la sortie 135 est reliée à l'unité d'échantillonnage et conversion analogique/numérique 400.

Comme cela ressort de la description qui précède, on obtient à la sortie 166 du monostable M165 des impulsions de période 202 microsecondes, légèrement supérieure à un sous-multiple de la période des créneaux de stimulation et qui se décalent donc progressivement par rapport à ceux-ci.

Les signaux présents à la sortie 166 du monostable M165 se retrouvent à la sortie 135 de la porte OU 131, lorsque la porte ET 172 est validée, c'est-à-dire lorsqu'un signal de niveau haut est appliqué sur l'entrée 173 de celle-ci par la sortie 202 de l'unité de traitement 200.

Comme cela a été précédemment évoqué, la troisième gamme est composée d'un créneau unique dont la durée est par exemple de 800 ms, avec un échantillonnage en temps réel de pas serrés jusqu'à 32 ms et de pas plus lâches pour le reste du temps.

L'échelon de stimulation d'une durée de 800 ms est généré par l'unité de traitement 200 sur sa sortie 203. Cette dernière est reliée à la troisième borne d'entrée 151 de la porte OU 111.

Par ailleurs, l'échantillonnage en temps réel est commandé directement par l'unité de traitement 200, par sa sortie 204 qui est reliée à la troisième borne 134 de la porte OU 131.

On a expliqué précédemment que les réponses successives aux créneaux de stimulation périodique peuvent être considérées comme la superposition des débuts de la réponse à l'échelon et de paliers dont la valeur au premier créneau évolue d'un créneau à l'autre.

Pour s'affranchir de cette perturbation, la Demanderesse propose de corriger la valeur d'am-plitude mesurée lors du $n^{ème}$ créneau grâce à la valeur de l'amplitude mesurée au temps équivalent lors du premier créneau.

Pour cela, en d'autres termes, la Demanderesse propose de prélever un échantillon de référence, pour chaque créneau de stimulation, à un instant fixe prédéterminé de ceux-ci.

Pour cela, on utilise le signal présent sur la sortie $\overline{Q}$ du monostable M106. Comme cela est représenté sur la cinquième ligne de la figure 9, la sortie $\overline{Q}$ de ce monostable M106 possède un front descendant synchrone des impulsions d'horloge d'origine. Ladite sortie $\overline{Q}$ du monostable M106 est reliée à l'entrée 177 d'une bascule JK176 qui réalise une division par 2 de la fréquence des signaux issus du monostable 106. Par conséquent la sortie de la bascule JK176 délivre des créneaux de périodes 200 µs non retardés par rapport à l'origine des temps.

Ces créneaux appliqués à l'unité d'échantillonnage 400 seront utilisés pour commander une acquisition auxiliaire d'échantillons de référence, sur chaque réponse à un créneau individuel à un temps fixe des périodes de ceux-ci. Pour ce faire, la sortie 178 de la bascule JK176 est reliée à la première borne d'entrée 180 d'une porte ET 179 à deux entrées, qui reçoit sur sa seconde entrée 181 le signal de validation de la première gamme issue de la sortie 201 de l'unité de traitement 200. La sortie 182 de la porte ET 179 est reliée à la première borne d'entrée 137 d'une porte OU 136 à deux entrées, dont la sortie 139 est reliée à l'unité d'échantillonnage 400, afin de commander l'acquisition d'échantillons de référence, lors de la première gamme.

Bien entendu, il est nécessaire de procéder de même à l'acquisition d'échantillons de référence lors de la seconde gamme.

Pour ce faire, on divise également la fréquence des créneaux non retardés de la première gamme issue de la bascule JK176, par 10.

Plus précisément, la sortie 178 de la bascule JK176 est reliée à une première borne d'entrée 184 d'une porte ET 183 à deux entrées. La seconde borne 185 de cette porte ET 183 est reliée à la sortie 202 de l'unité de traitement 200 validant la seconde gamme.

La sortie 186 de la porte ET 183 est reliée à l'entrée d'un organe 187 diviseur de fréquences par 10, dont la sortie 188 est reliée à la première borne d'entrée 190 d'une porte ET 189 à deux entrées, qui reçoit sur sa seconde borne d'entrée 191 le signal de validation de seconde gamme issu de la sortie 202.

La sortie 192 de la porte ET 189 à deux entrées est reliée à la seconde borne d'entrée 138 de la porte OU 136.

En conséquence, lors de la validation de la sortie 202 de l'unité de traitement 200, l'organe diviseur 187 génère en sortie des créneaux de périodes 2 ms.

Les signaux présents à la sortie de la bascule JK176 se retrouvent à la sortie 139 de la porte OU 136 lorsque la porte ET 179 est validée, c'est-à-dire lorsqu'un signal de niveau haut est appliqué sur l'entrée 181 de celle-ci par la sortie 201 de l'unité de traitement.

Par contre, un signal de période 2 ms est présent à la sortie de l'organe diviseur 187 lorsque la porte ET 183 est validée, (lorsqu'un signal de niveau haut est appliqué sur l'entrée 185 de celle-ci par la sortie 202 de l'unité de traitement, et de ce fait, la porte ET 189 étant en parallèle validée), le signal présent en sortie de l'organe 187 se retrouve à la sortie 139 de la porte OU 136.

Selon un mode de réalisation donné à titre d'exemple non limitatif, les compteurs 102, 103, 104, 121, 122, 123, 124, 161, 162, 163, et 164 sont du type 74 192, les monostables M105, M106 et M125, M165 sont du type 74 122, tandis que les bascules JK107, 176 sont du type 7476.

UNITE DE MESURE –300 –

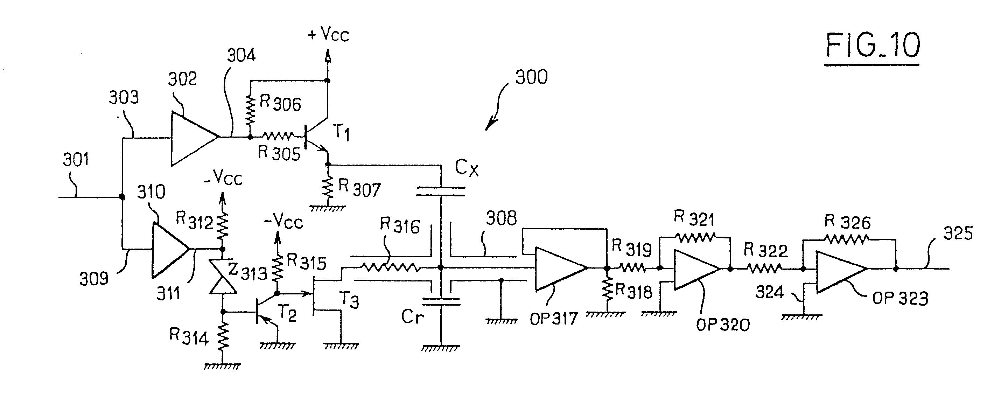

L'unité de mesure 300 illustrée schématiquement sur la figure 7 et détaillée sur la figure 10 a pour fonction d'opérer une mise en forme des créneaux d'excitation provenant de la sortie 113 de la base de temps 100, au point de vue amplitude, temps de montée et référence à zéro du niveau bas, de détecter la réponse de l'échantillon aux stimulus, à travers la chaîne de mesure formée du diviseur capacitif Cx et Cr, tout en réalisant l'isolement du point de sortie de la chaîne de mesure et le transfert de la réponse sans perturbation, ainsi qu'en réalisant la remise à zéro du point de sortie de la chaîne de mesure pendant les temps morts du stimulus.

La mise en forme des créneaux de stimulation est réalisée par un étage de mise en forme comprenant un étage amplificateur 302 et un transistor

$T_1$. Plus précisément, la sortie 113 de la base de temps 100 est reliée à l'entrée 301 de l'unité de mesure 300, qui est reliée elle-même à l'entrée 303 de l'opérateur amplificateur 302 précité.

La sortie 304 de cet opérateur est reliée par l'intermédiaire d'une résistance R305 à la base du transistor $T_1$ du type NPN monté en collecteur commun.

Comme cela est représenté sur la figure 10, le collecteur du transistor $T_1$ est en effet relié à une borne d'alimentation positive +VCC. Le collecteur du transistor $T_1$ est par ailleurs relié à la sortie 304 de l'opérateur 302 par l'intermédiaire d'une résistance R306.

L'émetteur du transistor $T_1$ est relié à la masse du montage par l'intermédiaire d'une résistance R307.

L'émetteur du transistor $T_1$ est également relié à une première borne du condensateur Cx à tester. La seconde borne de ce condensateur est reliée à une première borne du condensateur Cr intégré à la chaîne de mesure, qui est relié par sa seconde borne à la masse du montage.

Il en résulte que la chaîne de mesure est attaquée par des créneaux de stimulation issus de l'émetteur de transistor $T_1$.

Comme cela a été précédemment évoqué, le condensateur de référence Cr est choisi d'un ordre de grandeur d'environ 1000 fois supérieur à la valeur nominale du condensateur Cx à tester. Afin de respecter cette condition, l'unité de mesure 300 comporte avantageusement des moyens permettant de modifier par commutation le condensateur de référence Cr. Ces moyens n'ont pas été représentés sur la figure 10 afin de simplifier l'illustration.

La sortie de la chaîne de mesure est prise entre le point commun entre le condensateur Cx à tester et le condensateur Cr de référence. Le niveau de la tension à la sortie de cette cellule est faible (de l'ordre de 15 mV). De ce fait, la chaîne de mesure est blindée, comme cela est représenté en 308, sur la figure 10, afin d'éviter la superposition de bruit sur le signal utile.

On va maintenant décrire le dispositif permettant une remise à zéro du point de sortie de la chaîne de mesure pendant les temps morts des créneaux de stimulation.

Ce dispositif intervient en parallèle sur le condensateur de référence Cr. Bien entendu, ce dispositif doit perturber au minimum le comportement en capacitance pure du condensateur de référence. Néanmoins, la Demanderesse a démontré que sur toute la gamme de fréquences utiles, le dispositif de remise à zéro, pendant la phase active du processus, c'est-à-dire le niveau haut du créneau de stimulation, pouvait être assimilé à un schéma équivalent associant en parallèle une capacité constante et une résistance constante.

Ladite capacité, de l'ordre de quelques pF s'ajoute à la capacité du condensateur de référence Cr et peut aisément être prise en compte. La résistance parasite due au dispositif de remise à zéro est très élevée et ne perturbe pas, en pratique, le comportement capacitif du condensateur de référence.

L'entrée 301 de l'unité de mesure 300 est reliée à l'entrée 309 d'un étage amplificateur 310. La sortie 311 de celui-ci est reliée par l'intermédiaire d'une résistance R312 à une borne d'alimentation négative $-V_{cc}$. Par ailleurs, la sortie 311 de l'étage amplificateur 310 est reliée à la cathode d'une diode Zener $Z_{313}$. L'anode de cette diode $Z_{313}$ est reliée par l'intermédiaire d'une résistance R314 à la masse du montage. Par ailleurs, l'anode de cette diode $Z_{313}$ est reliée à la base d'un transistor bipolaire PNP T2 monté en émetteur commun.

L'émetteur de ce transistor T2 est en effet relié à la masse du montage, tandis que son collecteur est relié à une borne d'alimentation négative $-V_{cc}$ par l'intermédiaire d'une résistance de charge R315.

De plus, le collecteur du transistor T2 est relié à la grille d'un transistor à effet de champs T3 dont le canal source-drain est inséré, par l'intermédiaire d'une résistance R316 entre la masse du montage et le point commun aux condensateurs à tester Cx et de référence Cr.

Pendant la demi-alternance de niveau bas des créneaux d'excitation, le transistor T2 est conducteur et le transistor à effet de champ T3 dont la grille est portée au potentiel zéro est conducteur. A l'opposé, pendant les demi-alternances de niveau haut des créneaux d'excitation, le transistor T2 est bloqué et porte la grille du transistor à effet de champ T3 à un potentiel fortement négatif bloquant ce dernier.

La sortie de la chaîne de mesure Cx-Cr est reliée à un étage de découplage qui a pour but de transmettre la réponse en modifiant le moins possible l'admittance de la capacité de référence Cr.

Cet étage de découplage est formé d'un amplificateur opérationnel OP317 à correction interne de fréquences. Cet amplificateur opérationnel OP317 est relié directement par l'une de ses entrées au point commun aux condensateurs à tester Cx et de référence Cr, tandis que sa sortie est reliée directement à sa seconde entrée, pour former une boucle de contre-réaction.

L'amplificateur OP317 est ainsi monté en suiveur de tension. A titre d'exemple non limitatif, un tel amplificateur opérationnel OP317 peut être du type LH 0052. La Demanderesse a constaté qu'un tel dispositif donnait pleinement satisfaction. Le circuit précité présente une résistance d'entrée supérieure à $10^{10}$ ohms. Par ailleurs, même dans des conditions critiques pour lesquelles le condensateur de référence possède une valeur faible de l'ordre de $10^{-8}$ F, l'impédance d'entrée due à l'amplificateur opérationnel OP317 n'introduit une erreur sur la tangente de l'angle de pertes du diélectrique, que de l'ordre de $10^{-4}$ à 10 Hz. Par ailleurs, cette erreur diminue très vite quand la fréquence augmente.

L'étage de découplage précité est suivi d'au moins un étage d'amplification.

Plus précisément, selon le mode de réalisation représenté sur la figure 10, l'étage de découplage OP317 est suivi de deux amplificateurs inverseurs montés en cascade.

Plus précisément encore, la sortie de l'amplificateur OP317 est reliée à la masse du montage par l'intermédiaire d'une résistance R318. Par ailleurs, la sortie de l'amplificateur OP317 est reliée par l'intermédiaire d'une résistance R319 à la première borne d'entrée d'un amplificateur OP320 dont la seconde entrée est reliée à la masse. La sortie de cet amplificateur opérationnel OP320 est rebouclée sur ladite première entrée de celui-ci par l'intermédiaire d'une résistance R321. La sortie de l'amplificateur OP320 est reliée par l'intermédiaire d'une résistance R322 à la première entrée d'un deuxième amplificateur OP323 monté en inverseur. Pour ce faire, la seconde entrée 324 de l'amplificateur OP323 est reliée à la masse tandis que la sortie 325 de ce même amplificateur est rebouclée sur la première entrée par l'intermédiaire d'une résistance R326.

La sortie 325 de l'amplificateur opérationnel OP323 est reliée à l'unité d'échantillonnage 400.

Selon un mode de réalisation avantageux donné à titre d'exemple non limitatif, les amplificateurs opérationnels OP320 et OP323 sont du type AD507 et AD509, tandis que les étages amplificateurs 302 et 310 sont du type 7416.

Dans la pratique, différentes perturbations sont apportées au signal, toutefois, la Demanderesse a démontrée que:

1) bien que le temps de montée des créneaux de stimulation générée par le transistor T1 n'est pas nul, mais de l'ordre de 50 ns l'effet de cette perturbation est négligeable dans le domaine des temps supérieur ou égal à 1 µs. Pour le domaine inférieur à 1 µs, le décalage des grandeurs temporelles est de l'ordre de 25 ns,

2) l'influence de la résistance introduite en parallèle sur le condensateur de référence Cr par l'impédance d'entrée de l'amplificateur de découplage OP317 et l'impédance de sortie du circuit de remise à zéro (transistor à effet de champ T3) qui est supérieur à $10^{10}$ ohms, est négligeable.

3) le gain des étages suiveurs est parfaitement constant sur toute la gamme des fréquences utiles.

Le dispositif de test conforme à la présente invention doit permettre le contrôle des valeurs usuelles de condensateur, et doit donc couvrir au minimum la gamme de 1 pF à µF. Cette gamme ne peut être couverte avec un condensateur de référence unique. Pour ce faire, la Demanderesse propose de diviser le processus de mesure en deux gammes principales.

La première gamme principale concerne le test des condensateurs possédant une capacité comprise entre 0,3 pF et 30 000 pF.

La seconde gamme principale concerne le test des condensateurs présentant une capacité supérieure à 30 000 pF.

La première gamme principale se divise elle-même en cinq sous-gammes auxiliaires.

La première sous-gamme auxiliaire concerne les condensateurs à tester possédant une capacité allant de 0,3 à 3 pF. Cette première sous-gamme auxiliaire utilise une capacité de référence de 1000 pF.

La seconde sous-gamme auxiliaire concene les condensateurs à tester présentant une capacité allant de 3 à 30 pF. Cette seconde sous-gamme auxiliaire utilise une capacité de référence de 10 000 pF.

La troisième sous-gamme auxiliaire concerne les condensateurs à tester présentant une capacité allant de 30 à 300 pF. Cette troisième sous-gamme auxiliaire utilise une capacité de référence de 100 000 pF.

La quatrième sous-gamme auxiliaire concerne les condensateurs à tester présentant une capacité allant de 300 à 3000 pF. Cette quatrième sous-gamme auxiliaire utilise une capacité de référence de 1 µF.

La cinquième sous-gamme auxiliaire concerne les condensateurs à tester présentant une capacité allant de 3000 pF à 30 000 pF. Cette cinquième sous-gamme auxiliaire utilise une capacité de référence de 10 µF.

Pour la seconde gamme de mesure principale qui concerne les dondensateurs présentant une capacité supérieure à 30 000 pF, la Demanderesse propose, pour éviter une perte de définition, d'inverser le condensateur de référence Cr et le condensateur à tester Cx, par rapport au mode de réalisation représenté sur la figure 10. Bien entendu, dans un tel cas, le condensateur de référence Cr sur lequel sont appliqués les créneaux de stimulation doit respecter la relation $Cr \simeq Cx/1000$. La réponse détectée par l'étage de découplage (amplificateur OP317) est alors prise aux bornes de condensateur à tester Cx. La Demanderesse a démontré que la réponse ainsi prélevée répond à la relation:

$$(13) \qquad v(t) = V \frac{C_r}{C_x^2} \left[ 2 C_x - \left\{ C_x + \frac{1}{R_s} t + \sum C_i (1 - e^{-t/R_i C_i}) \right\} \right]$$

On remarquera en effet que cette expression (13), applicable pour la seconde gamme principale de mesure est très proche des relations précédemment exposées. De ce fait, l'unité de traitement pourra utiliser le même type de traitement et les mêmes algorithmes que ceux qui seront évoqués par la suite.

## UNITE D'ECHANTILLONNAGE-CONVERSION ANALOGIQUE/NUMERIQUE – 400 –

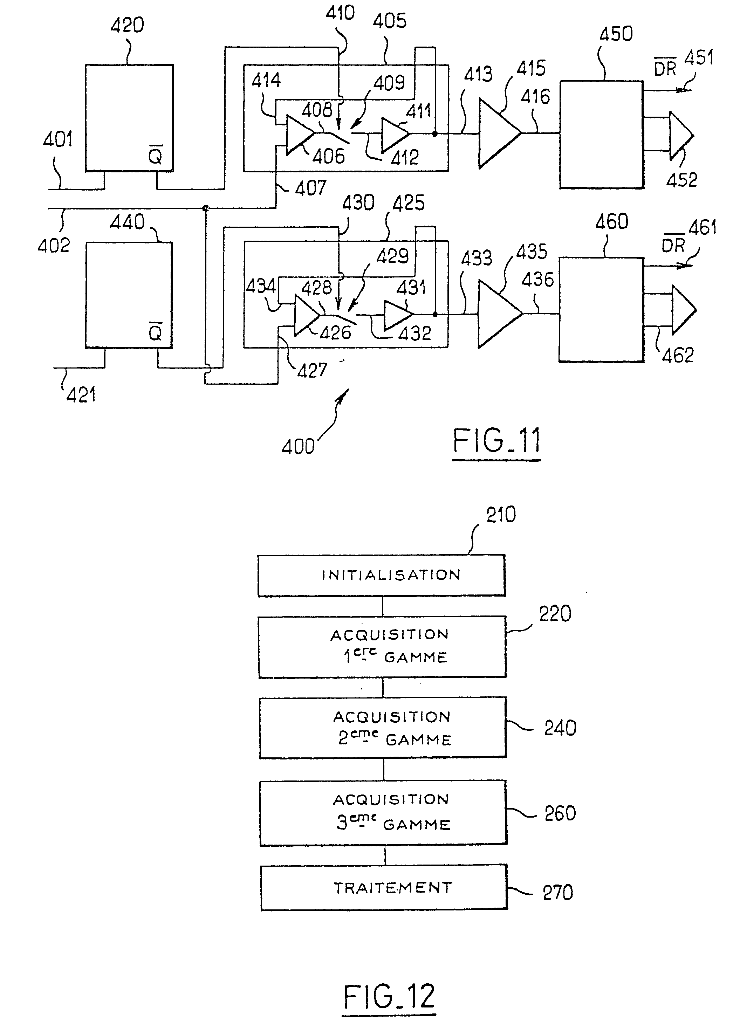

L'unité d'échantillonnage et de conversion 400 schématiquement représentée sur la figure 7 et représentée plus en détail sur la figure 11 a pour fonction essentielle d'opérer l'échantillonnage des données, tout en assurant l'interface de transfert entre l'unité de mesure 300 et l'unité de traitement 200.

Plus précisément, l'unité d'échantillonnage et de conversion 400 a pour but de transformer en un code binaire (sur 10 bits) des valeurs échantillonnées de la réponse analogique en provenance de l'unité de mesure 300.

Comme cela est représenté sur les figures 7 et 11, l'unité d'échantillonnage et de conversion 400 est reliée à l'unité de mesure 300 par l'intermédiaire de son entrée 402, à la base de temps 100 par l'intermédiaire de ses entrées 401 et 421, et enfin, en aval, à l'unité de traitement 200 par l'intermédiaire de ses sorties 451, 452 et 461, 462.

La fonction de chacune de ces entrées et sorties sera explicitée ultérieurement.

D'une façon générale, comme cela est représenté sur la figure 11, l'unité d'échantillonnage 400 comprend en cascade, un échantillonneur bloqueur 405, un amplificateur à gain ajustable 415 et un convertisseur analogique/numérique 450.

Toutefois, comme cela a été précédemment évoqué, le dispositif est adapté pour prélever outre des échantillons de mesure qui transitent par la chaîne échantillonneur bloqueur 405 – amplificateur 415 et convertisseur 450, des échantillons de référence prélevés à un instant fixe de chaque créneau de stimulation. Pour cette raison, l'unité d'échantillonnage et de conversion comprend en parallèle de la chaîne précitée une seconde chaîne par laquelle transitent les données de référence et qui comprend également en cascade un échantillonneur bloqueur 425 suivi d'un amplificateur à gain ajustable 435 et d'un convertisseur analogique/numérique 460.

L'échantillonneur bloqueur 405 a pour but d'assurer, sous le contrôle de la base de temps 100 l'acquisition puis le maintien des échantillons analogiques.

L'échantillonneur bloqueur 405, schématisé sur la figure 11, comprend essentiellement un amplificateur opérationnel 406, un interrupteur commandable 409 et un étage amplificateur 411.

Une première entrée 407 de l'amplificateur opérationnel 406 est reliée à l'entrée 402 de l'unité d'échantillonnage 400, pour recevoir les signaux analogiques provenant de l'unité de mesure 300. La sortie 408 de l'amplificateur opérationnel 406 est susceptible d'être reliée par l'intermédiaire de l'interrupteur commandable 409 à l'entrée 412 de l'étage amplificateur 411.

La sortie de cet étage amplificateur 411 est reliée à la seconde entrée 414 de l'amplificateur opérationnel 406. L'interrupteur commandable 409 est contrôlé par l'état d'un signal appliqué sur l'entrée 410 de l'échantillonneur bloqueur 405.

Cette entrée 410 est par ailleurs reliée à la sortie Q̄ d'un monostable 420 dont l'entrée est reliée à l'entrée 401 de l'unité 400. Cette entrée 401 est connectée à la sortie 135 de la base de temps 100 pour recevoir les impulsions d'échantillonnage générés par celle-ci.

De façon similaire, le second échantillonneur bloqueur 425 comprend un amplificateur opérationnel 426 dont une première entrée 427 est reliée à l'entrée 402 de l'unité d'échantillonnage pour recevoir les signaux analogiques provenant de l'unité de mesure 300. La sortie 428 de l'amplificateur opérationnel 426 est susceptible d'être reliée par l'intermédiaire d'un interrupteur commandable 429 à l'entrée 432 d'un étage amplificateur 431 dont la sortie est rebouclée sur la seconde entrée 434 de l'amplificateur 426. L'interrupteur commandable 429 est contrôlé par l'état de l'entrée 430 du circuit 425. Cette entrée 430 est reliée à la sortie Q̄ d'un monostable 440 dont l'entrée est reliée à l'entrée 421 de l'unité 400. Cette entrée 421 est connectée à la sortie 139 de la base de temps pour recevoir les impulsions d'échantillonnage de référence.

Dans la pratique, les échantillonneurs bloqueurs 405, 425 peuvent être formés du circuit type AD 582 commercialisé par la Société ANALOG DEVICES. Un tel circuit peut assurer l'échantillonnage de signaux analogiques de 10 V crête à crête en un temps de 6 µs. Par ailleurs, les échantillonneurs bloqueur 405, 425 présentent un temps de maintien des informations sur leur sortie respective 413, 433 de l'ordre de 25 µs, tout à fait compatible avec le temps de conversion de 25 µs exigé par les convertisseurs 450, 460, disposés en aval.

L'homme de l'art comprendra aisément que l'échantillonnage des données de mesure est réalisé par le processus de fermeture-ouverture de l'interrupteur commandable 409 intégré à l'échantillonneur bloqueur 405, ce processus de fermeture-ouverture étant commandé par les impulsions d'échantillonnage issues de la sortie 135 de la base de temps 100.

De façon similaire, l'échantillonnage de référence est établi par le processus de fermeture-ouverture de l'interrupteur commandable 429 intégré à l'échantillonneur 425, ce processus de fermeture-ouverture étant contrôlé par les impulsions d'échantillonnage issues de la sortie 139 de la base de temps 100.

Bien entendu, chacun des échantillonneurs bloqueurs 405, 425 présente un temps de fermeture de la porte d'échantillonnage non nul, ainsi qu'un temps de poursuite de la tension de sortie par rapport à la tension d'entrée non nul.

Ces temps pourraient, en théorie, perturber la mesure.

Toutefois, on rappelle que selon l'invention, les créneaux de stimulation présents sur la sortie 113 de la base de temps 100 sont retardés par rapport aux impulsions d'échantillonnage. Il en résulte que les premiers échantillons susceptibles d'être retenus sont établis sur le niveau bas des créneaux de stimulation et sont donc de valeur nulle. De ce fait, en retenant comme premier échantillon valide, le premier échantillon non nul, les retards propres au processus d'échantillonnage-blocage ne perturbent pas la mesure.

Par ailleurs, comme cela sera exposé en détail par la suite, la valeur à l'origine de la courbe de réponse est déterminée non point sur la base de la première donnée acquise, mais par extrapolation sur la base de la deuxième et de la troisième données.

Les sorties 413 et 433 des échantillonneurs-bloqueurs 405, 425 sont reliées respectivement aux entrées d'amplificateurs à gain ajustable 415, 435. Ces derniers permettent d'adapter la dynamique de sortie de l'échantillonneur-bloqueur 405, 425 respectivement à la dynamique d'entrée du convertisseur analogique/numérique 450, 460.

Enfin, les sorties 416 et 436 respectives des amplificateurs 415 et 435 sont reliées aux entrées des convertisseurs 450 et 460. Ces derniers peuvent être formés par exemple de circuit du type AD 571. De tels circuits convertissent un signal analogique échantillonné d'entrée en mots de 10 bits.

Les signaux numériques générés respectivement par les convertisseurs 450 et 460 sont disponibles sur les bus de données 452 et 462 respectifs de ces dispositifs, qui sont reliés à l'unité de traitement 200.

Par ailleurs, lorsque les données numériques sont disponibles sur les bus 452 et 462 précités, les convertisseurs 450 et 460 génèrent sur leurs sorties 451, 461, codé $\overline{DR}$ un signal de niveau bas. Les données numériques restent présentes sur les bus 452, 462, pour exploitation par l'unité de traitement 200, jusqu'à la fin du créneau de commande appliqué sur les convertisseurs 450 et 460 par la sortie Q des monostables 420 et 440 respectivement, comme représenté sur la figure 11.

Il en résulte que lorsque l'un des monostables 420–440 présente sur sa sortie $\overline{Q}$ un signal de niveau haut, l'échantillonneur-bloqueur associé procède à l'échantillonnage du signal numérique, tandis que le signal Q dudit monostable étant au niveau bas, le convertisseur associé blanchit sa sortie.

Inversement, lorsque le signal $\overline{Q}$ d'un monostable passe au niveau bas, l'échantillonneur-bloqueur passe à l'état bloqué, et le signal Q du monostable, en correspondance, passant à l'état haut, le convertisseur analogique/numérique associé commence la conversion.

UNITE DE TRAITEMENT 200

Cette unité a pour fonctions essentielles de piloter la base de temps 100 par l'intermédiaire de signaux de séquencement, pour la génération des différentes salves de créneaux d'excitation et d'impulsions d'échantillonnage et d'assurer les relations avec les périphériques conventionnels 500, 600 et 700 et le cas échéant un robot 800, ainsi que d'opérer un traitement des signaux issus de l'unité 400 d'échantillonnage et de conversion analogique/numérique.

Seul le processus de traitement va maintenant être décrit en détail, les autres fonctions de l'unité de traitement-séquencement de la base de temps et contrôle des périphériques ayant précédemment été évoquées.

Comme cela est schématiquement illustré sur la figure 12, le processus de traitement comprend successivement une phase 210 d'initialisation, une phase 220 d'acquisition de la première gamme de données, une phase 240 d'acquisition de la seconde gamme de données, une phase 260 d'acquisition de la troisième gamme de données et enfin une phase 270 de traitement proprement dit.

La phase d'initialisation 210 permet d'introduire les coefficients nécessaires pour l'accomplissement de la phase de traitement 270, c'est-à-dire les coefficients nécessaires pour la détermination des paramètres (étapes 272, 273, 274 et 275) et les normes de tolérance permettant le classement des condensateurs (étape 276).

Comme cela a été précédemment évoqué, l'acquisition des données, qui a pour but de stocker celles-ci avant l'opération de traitement, est divisée en trois phases 220, 240 et 260 respectivement, correspondant aux trois gammes de créneaux d'excitation et d'impulsions d'échantillonnage définies par la base de temps 100.

Les sous-programmes de la première et de la seconde phases d'acquisition 220, 240, prennent en compte en plus de l'échantillon de mesure dû aux impulsions d'échantillonnage générées à la sortie 135 de la base de temps 100, l'échantillon de référence dû aux impulsions d'échantillonnage générées à la sortie 139 de la base de temps 100, pour compenser l'effet des paliers induits par la remise à zéro, et qui évolue d'un créneau à l'autre.

Les corrections sont effectuées avant stockage des données.

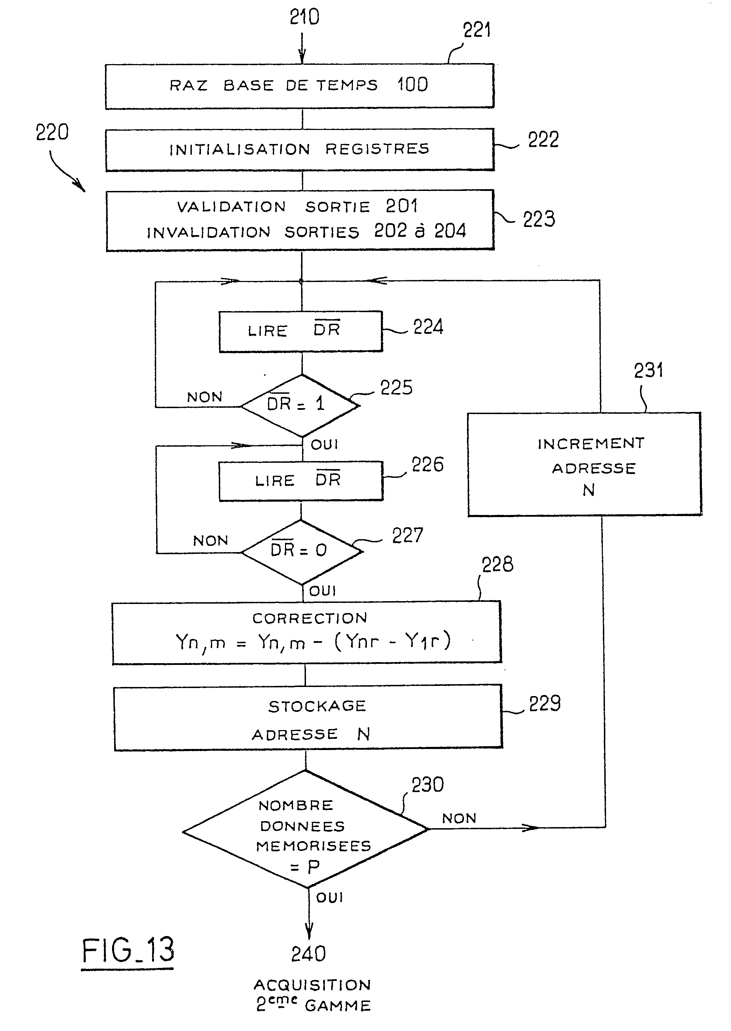

On va maintenant décrire le processus 220 d'acquisition de la première gamme de données, en regard de la figure 13.

Comme cela est représenté sur cette figure 13, le processus 220 commence par une étape 221 de remise à zéro avec temporisation de la base de temps 100.

L'étape 221 est suivie d'une étape 222 d'initialisation des registres déterminant d'une part le nombre de données mémorisées préalablement et d'autre part le numéro de l'adresse de la première donnée.

L'étape 222 est suivie de l'étape 223 au cours de laquelle l'unité de traitement valide la sortie 201, en appliquant un signal de niveau haut sur celle-ci, et invalide les sorties 202, 203 et 204 en appliquant un signal de niveau bas sur ces dernières.

Le système est alors prêt pour l'acquisition des données. Cette acquisition est cependant conditionnée par le test de la ligne $\overline{DR}$ du convertisseur analogique/numérique 450. En effet, un signal de niveau haut sur la ligne $\overline{DR}$ indique qu'une donnée est en cours de conversion, et le transfert ne doit être autorisé que lorsque la ligne $\overline{DR}$ passe au niveau bas.

Ce processus d'attente est déterminé par les étapes schématiques 224 à 227.

A l'étape 224, qui suit l'étape 223, l'unité de traitement lit l'état de la ligne $\overline{DR}$ et teste l'état de la ligne $\overline{DR}$ à l'étape 225.

Si la ligne $\overline{DR}$ est au niveau haut, une donnée étant en cours de conversion, l'étape 225 est suivie de l'étape 226 qui va déterminer une boucle d'attente.

Si par contre, la ligne $\overline{DR}$ n'est pas au niveau haut, l'étape 224 est réitérée après l'étape 225.

Au cours de l'étape 226, l'unité de traitement 200 lit à nouveau l'état de la ligne $\overline{DR}$ et cet état est testé à l'étape suivante 227.

Si la ligne $\overline{DR}$ est toujours au niveau haut, une donnée étant en cours de conversion, l'étape 226 de lecture de l'état de la ligne $\overline{DR}$ est réitérée.

Si par contre, la ligne $\overline{DR}$ est passée au niveau bas, la conversion analogique/numérique étant terminée, l'étape 227 est suivie de l'étape 228 de correction.

Cette procédure de correction a pour but d'annuler l'effet des paliers dûs à la remise à zéro du signal au cours des demi-alternances de niveau bas des créneaux d'excitation.

La correction sur le signal de mesure $Y_{nm}$ prélevé à l'instant m du $n^{ème}$ créneau d'excitation est opérée en utilisant les signaux de référence (dus aux signaux d'échantillonnage de référence générés sur la sortie 139 de la base de temps 100).

Plus précisément, la correction utilise d'une part l'échantillon de référence $Y_{1r}$ pris au cours du premier créneau d'excitation à l'instant r et l'échantillon de référence $Y_{nr}$ pris au $n^{ème}$ créneau à l'instant équivalent r.

La correction est réalisée sur la base de la relation:

(5)     $Y'_{nm} = Y_{nm} - (Y_{nr} - Y_{1r})$.

L'étage 228 de correction est suivie de l'étape 229 de stockage.

Cette dernière étape 229 est suivie d'une étape de test 230 au cours de laquelle l'unité de traitement 200 recherche si le nombre de données mémorisées égale un nombre p prédéterminé.

En l'espèce, selon l'exemple précédemment donné, p = 500 puisque 500 données de 0,2 µs doivent être prélevées.

Si le test de l'étape 230 est négatif, l'étape 224 est réitérée après incrémentation de l'adresse de stockage de données au cours de l'étape intermédiaire 231.

Si le test de l'étape 230 est positif, la phase d'acquisition de la première gamme est terminée et cette étape 230 est suivie de la phase 240 d'acquisition de la seconde gamme.

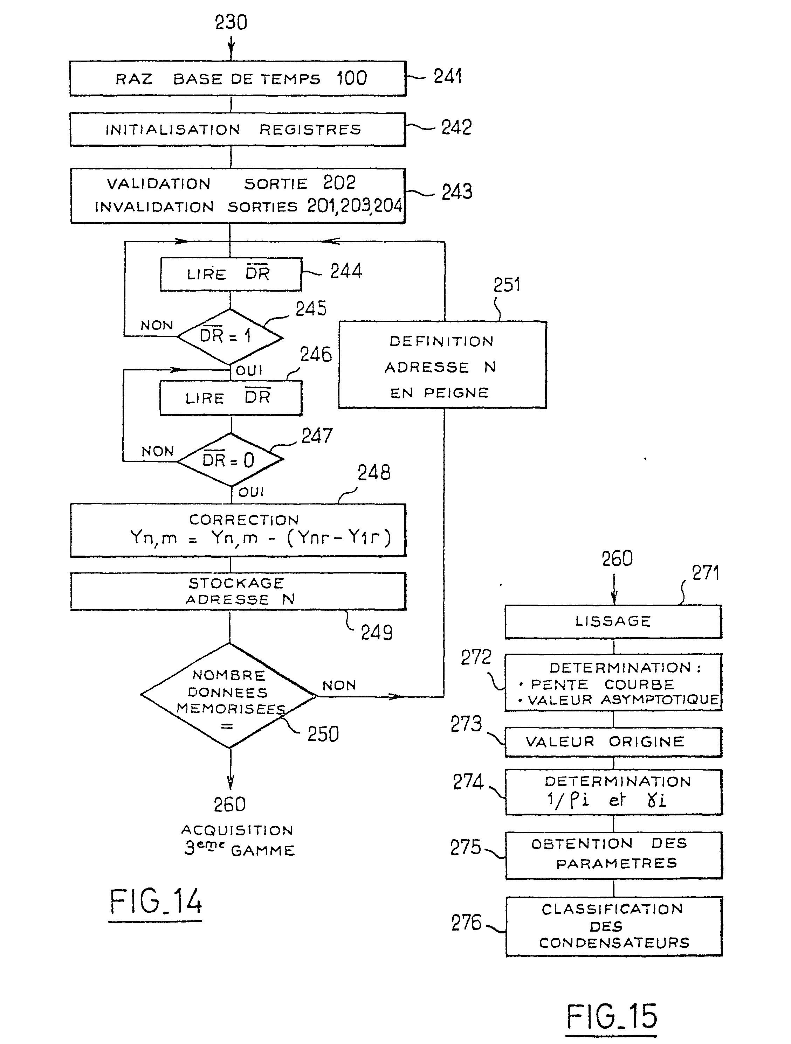

On va maintenant décrire le processus 240 d'acquisition de la seconde gamme de données en regard de la figure 14.

Comme cela est représenté sur cette figure 14, le processus 240 commence par une étape 241 de remise à zéro avec temporisation de la base de temps 100.

L'étape 241 est suivie d'une étape 242 d'initialisation des registres déterminant d'une part le nombre de données mémorisées au cours de la seconde phase d'acquisition, et d'autre part le numéro de l'adresse de mémorisation de la première donnée de la seconde phase d'acquisition.

L'étape 242 est suivie de l'étape 243 au cours de laquelle l'unité de traitement 200 valide la sortie 202, en appliquant un signal de niveau haut sur celle-ci, et invalide les sorties 201, 203 et 204, en appliquant un signal de niveau bas sur ces dernières.

Le système est alors prêt pour la seconde phase d'acquisition de données.

A l'étape 244 qui suit l'étape 243, l'unité de traitement 200 lit l'état de la ligne $\overline{DR}$, et teste l'état de cette ligne à l'étape 245.

Si la ligne $\overline{DR}$ est au niveau haut une donnée étant en cours de conversion, l'étape 245 est suivie de l'étape 246 qui va déterminer une boucle d'attente.

Si par contre, la ligne $\overline{DR}$ n'est pas au niveau haut, l'étape 244 est réitérée après l'étape 245.

Au cours de l'étape 246, l'unité de traitement 200 lit à nouveau l'état de la ligne $\overline{DR}$ et cet état est testé à l'étape suivante 247.

Si la ligne $\overline{DR}$ est toujours au niveau haut, une donnée étant toujours en cours de conversion, l'étape 246 de lecture de l'état de la ligne $\overline{DR}$ est réitérée.

Si par contre la ligne $\overline{DR}$ est passée au niveau bas, la conversion analogique/numérique étant terminée l'étape 247 est suivie de l'étape 248 de correction.

Ce processus de correction, de façon similaire à l'étape 228 précitée relative à la première phase d'acquisition, est opéré sur le signal de mesure $Y_{nm}$ prélevé à l'instant m du $n^{ème}$ créneau d'excitation en utilisant l'échantillon de référence $Y_{1r}$ pris au cours du premier créneau d'excitation à l'instant r et l'échantillon de référence $Y_{nr}$ pris au $n^{ème}$ créneau à l'instant équivalent r, sur la base de la relation:

(5)     $Y'_{nm} = Y_{nm} - (Y_{nr} - Y_{1r})$.

L'étape 248 de correction est suivie de l'étape 249 de stockage.

Cette étape de stockage 249 est suivie d'une étape de test 250 au cours de laquelle l'unité de traitement 200 recherche si le nombre de données mémorisées égale un nombre q prédéterminé.

En l'espèce q = 50 (5 données utiles retenues pour chacun des 10 créneaux d'excitation) puisque 50 données sont prélevées avec un pas de 20 µs.

Si le test de l'étape 250 est négatif, l'étape 244 est réitérée après définition d'une nouvelle adresse de mémorisation à l'étape intermédiaire 251. Celle-ci sera explicitée par la suite.

Si par contre, le test de l'étape 250 est positif, la seconde phase d'acquisition 240 est terminée, et l'étape 250 est suivie de l'étape 260 d'acquisition de la troisième gamme.

Au cours de la seconde phase d'acquisition, les données ne sont pas obtenues dans leur ordre naturel: 1ère, 2de ... mais selon une séquence présentant un entrelacement: 1ère, 6ème, 11ème ... 2de, 7ème, 12ème ... due au fait que 5 échantillons sont prélevés pour chaque créneau de stimulation.

Pour cette raison, à l'étape 251, l'unité de traitement doit définir les adresses de mémorisation des données selon une séquence entrelacée respectant l'ordre réel d'acquisition des données.

L'organigramme représenté sur la figure 14 a été schématisé pour simplifier cette figure.

Cet organigramme doit en fait éliminer les échantillons de mesure de valeurs nulles obtenues au cours des demi-alternances de niveau bas des créneaux d'excitation.

Par ailleurs, afin d'éviter une redondance des informations mémorisées, on peut éviter la mémorisation des données correspondant à des temps pour lesquels des données ont déjà été mémorisées au cours de la première phase d'acquisition 220.

De plus, pour réaliser les étapes de correction 228 et 248, l'unité de traitement 200 doit prendre en compte les échantillons de référence au fur et à mesure de leur génération.

La troisième phase d'acquisition 260 a pour but d'étudier le comportement du condensateur en basse fréquence.

Au cours de cette troisième phase, l'unité de traitement 200 génère directement un échelon unique de stimulation ainsi que des impulsions d'échantillonnage en temps réel.

La troisième phase d'acquisition 260 peut être opérée sur la base des trois sous-étapes suivantes.

Dans un premier temps, l'acquisition de 200 données est opérée de façon continue avec un pas d'échantillonnage de 160 µs jusqu'à 32 ms.

Dans un second temps, l'acquisition de 9 données est opérée avec un pas de 8 ms jusqu'à 96 ms.

Enfin, dans un troisième temps, 14 données sont acquises avec un pas de 48 ms jusqu'à 720 ms.

Ainsi, cette troisième phase d'acquisition comporte 223 points.

On va maintenant décrire la phase de traitement 270 proprement dite, en regard de la figure 15.

La phase de traitement 270 commence par une étape 271 de lissage des données brutes mémorisées non point dans leur ordre d'acquisition mais dans l'ordre naturel des échantillons.

Cette étape de lissage a pour but d'affiner les données, affectées de perturbations aléatoires dues principalement à l'erreur de quantification et à l'erreur sur le temps d'acquisition.

Pour cela, le lissage est réalisé par une méthode de moyennage mobile.

Plus précisément, on définit dans un intervalle de temps $t_k - t_{k+n+1}$ (k et n étant des entiers) la valeur moyenne $y_m$ d'un échantillon affectée au temps $\frac{t_{k+n}}{2}$ sur la base de la relation:

$$(14) \qquad y_m = \frac{\dfrac{y_k + y_{k+n+1}}{2} + \displaystyle\sum_{i=k+1}^{n} y_i}{n}$$

Cependant, le nombre de points d'appui considérés pour l'établissement de la moyenne mobile augmente du début de chaque gamme à la fin de celle-ci pour tenir compte du fait que les variations du signal sont plus rapides au début de gamme qu'en fin de gamme.

A titre d'exemple, pour la première gamme, les 10 premiers points ne sont pas lissés, les points suivants sont lissés sur trois points et la fin de gamme utilise un appui sur 8 points.

L'unité de traitement procède alors à la détermination des paramètres au cours des étapes 272, 273 et 274 qui seront explicitées ultérieurement.

Cependant, les données analysées au cours de ces étapes 272, 273 et 274 sont des échantillons de tension numérisés y(ti) et non les valeurs de capacité C(t). La correspondance entre les deux grandeurs s'exprime par la loi d'étalonnage:

$$(15) \qquad C(t) = K\,[y(t)+a]$$

La Demanderesse a déterminé sur cette base que la loi de correspondance étant linéaire, on peut procéder à l'acquisition des paramètres caractéristiques directement sur la fonction y(t) sous la forme de paramètres intermédiaires, au cours des étapes 272, 723 et 274, en transformant ultérieurement ceux-ci en paramètres réels $C\infty$, $1/Rs$, Ci, Ri et Cs à l'étape consécutive 275.

On peut écrire, pour les paramètres utiles:

$$(1) \qquad C(t) = C_\infty + \frac{t}{Rs} + \sum_i Ci\,(1 - e^{-t/\tau i})$$

et pour les paramètres intermédiaires:

$$(16) \qquad y(t) = \gamma_\infty + \frac{t}{\rho s} + \sum_i \gamma_i\,(1 - e^{-t/\tau i})$$

avec les lois de conversion suivantes:

$$(17) \quad C\infty = K\gamma\infty + a$$
$$(18) \quad Ci = K\gamma i$$
$$(19) \quad Cs = K\gamma\infty + a + K\,\Sigma\,\gamma i$$
$$(20) \quad \tau i = RiCi = \gamma i\,\rho i$$

$$(21) \qquad Ri = \frac{\rho i}{K}$$

$$(22) \qquad Rs = \frac{\rho s}{K}$$

Dans un premier temps, au cours de l'étape 272, l'unité de traitement 200 détermine les paramètres intermédiaires $\gamma s$ et $1/\rho s$.

Le paramètre $1/\rho s$ est déterminé par la pente de la courbe pour des temps longs.

Le paramètre $\gamma s$ est déterminé par prolongation de la pente à l'origine.

Plus précisément, la pente de la courbe est déterminée sur plusieurs points par exemple aux instants 32 ms, 96 ms et 720 ms et les valeurs relatives de la pente sont comparées.

Si les trois pentes sont égales, elles indiquent que dans le domaine de fréquence supérieure à $1/2\pi 32\ ms \simeq 5$ Hz, le condensateur présente un comportement de conductance $1/\rho s$.

On déduit alors le paramètre $\gamma s$ sur la base de la relation:

$$(23)\quad \gamma s = y_{200} - 200 \times \frac{1}{\rho s}\ \text{dans laquelle}\ 1/\rho s\ \text{est la}$$

pente du $200^{\text{ème}}$ point et $y_{200}$ est la donnée de tension pour le $200^{\text{ème}}$ point.

Si la première pente (32 ms) est différente des deux dernières (96 ms, 720 ms), celles-ci étant cependant égales, l'unité de traitement 200 détermine que le condensateur présente un comportement de conductance déterminé par la pente à l'instant 96 ms, à partir de la fréquence $1/2\pi$ $96\ ms \simeq 1,6$ Hz.

Le paramètre $\gamma s$ est alors déterminé sur la base d'une relation équivalente à la relation (23).

Si par contre, les trois pentes sont différentes, elles indiquent la présence d'un phénomène de relaxation qui évolue à temps long.

Dans un second temps au cours de l'étape 273 l'unité de traitement 200 détermine le paramètre intermédiaire $\gamma_x$.

En théorie, le paramètre $\gamma_x$ correspond à la première valeur stockée. Cependant, ce point est entaché d'une erreur due à l'incertitude sur le temps d'échantillonnage au début de la réponse, d'une part, et sur la valeur du premier point stocké, d'autre part.

Pour cette raison, selon l'invention, le paramètre $\gamma_x$ est déterminé par extrapolation à partir des deuxième et troisième points stockés.

Plus précisément, selon l'invention, on prolonge la pente relevée entre le 2ème et le 3ème point jusqu'à l'abscisse:

$$(3) \qquad t_2 - \frac{3\delta T}{2}$$

relation dans laquelle:

$t_2$ représente l'instant d'échantillonnage pour le 2ème point stocké, et

$\delta T$ représente le pas d'échantillonnage.

La relation (20) est tirée du raisonnement suivant:

Le temps $t'o$ de l'origine vraie de la réponse est inconnu. Il peut être égal à $t_2-\delta T$ dans le cas où on fait un échantillonnage idéal du premier point et égal à $t_2-2\delta T$ dans l'autre cas extrême, ce qui conduit à situer en moyenne l'origine au temps:

$$to = t_2 - \frac{3\delta T}{2}$$

La Demanderesse a déterminé que l'erreur commise sur la détermination du paramètre $\gamma_x$ grâce au processus précité, erreur qui est due d'une part à l'incertitude sur le temps d'origine vraie compris dans l'intervalle $t_2 - 2\delta T \leqslant t'o \leqslant t_2 - \delta T$ et d'autre part une certitude sur l'amplitude, est négligeable.

Dans un troisième temps, au cours de l'étape 274, l'unité de traitement 200 détermine les paramètres intermédiaires $1/\rho i$ et $\gamma i$.

En considérant un domaine de relaxation unique, le paramètre intermédiaire $1/\rho i$ est, en théorie, obtenu en retranchant de la pente initiale le terme de la conductivité $1/\rho s$, puisque la pente initiale égale $1/\rho s + 1/\rho i$. Le paramètre intermédiaire $\gamma i$ est obtenu alors à partir de la relation $\gamma i = \gamma_s - \gamma_x$.

Dans le cas de plusieurs domaines de relaxation séparés, les termes $1/\rho i$ et $\tau i$ sont déterminés sur la base de l'analyse des pentes:

$$\lambda(t) = \sum_{i=1}^{n} \frac{1}{Ri} \, e^{-t/\tau i}$$

et $\lambda'(t)$, comme cela a été évoqué précédemment en regard des figures 4 et 5. Le terme $\gamma i$ est alors déduit de la relation (20) $\tau i = \rho i \, \gamma i$.

En pratique, on exploite le fait que sur chaque gamme les points sont séparés par un intervalle de temps régulier égal au pas d'échantillonnage.

Au lieu de déterminer la pente $\lambda(t)$, on effectue tout simplement la différence entre deux données pour obtenir la courbe $\mu(t) = \delta T \cdot \lambda(t)$, courbe qui est proportionnelle à la pente $\lambda(t)$.

Le calcul des temps de relaxation $\tau i$ est alors établi par détection des maximums de la courbe $\mu'(\log t)$.

Toutefois, on évite le calcul des logarithmes qui exigerait un temps de traitement trop long, en affichant simplement la différence entre les ordonnées de la courbe $\mu(t)$ dont les abscisses ta et tb sont dans un rapport constant K que l'on choisit par exemple égal à 2. On obtient ainsi la pente de la courbe $\mu'(\log t)$ au point qui est une moyenne proportionnelle des 2 temps ta, tb utilisés.

Ces calculs sont faits en prenant successivement pour temps ta les temps $t_1, t_2, t_3 \ldots t_i$ d'échantillonnage et le temps tb respectivement associé $t_2, t_4, t_6 \ldots t_{2i}$, jusqu'au dernier temps disponible dans la gamme.

Dans chaque gamme les pentes relevées correspondent par conséquent aux temps $\sqrt{2} \, \delta T$.

Sur cette base, le temps de relaxation $\tau j$ de chaque branche active du modèle de FOSTER est déterminé par détection de l'abscisse des maximum de la courbe $\mu'(\log t)$.

On repère également les abscisses tj et $tj + 1$ des minimum autour de $\tau j$. Ces instants correspondent à la présence des paliers sur la courbe $\mu(t)$, comme cela ressort d'une comparaison des figures 4 et 5.

L'unité de traitement 200 détecte ensuite les ordonnées $\mu(tj)$ et $\mu(tj + 1)$ de la courbe $\mu(t)$ pour les temps tj et $tj + 1$. La différence entre ces ordonnées $(\mu(tj + 1) - \mu(tj))$ donne directement la valeur $1/\tau i$ et donc la valeur $\tau i$.

On a exposé précédemment (chapitre PRINCIPE DE LA MESURE) que la réponse répétitive à chaque créneau est identique au début de la réponse à l'échelon jusqu'à la fin de la durée du créneau, à un facteur de correction près égal à

$$\frac{1}{1 + e^{-T/\tau i}}$$

qui est égal à l'unité pour $\tau i \ll T$.

Dans la mesure où les trois gammes d'acquisition se recouvrent, on peut limiter l'exploitation des données à des temps équivalents ne dépassant pas 0,5T.

Le facteur de correction ci-dessus rappelé est donc très proche de l'unité et le processus de correction correspondant peut être négligé.

Enfin, comme cela a été précédemment évoqué à l'étape 275, l'unité de traitement 200 détermine les paramètres réels, à partir des paramètres intermédiaires précités, sur la base des relations (17) à (22).

Le passage des paramètres intermédiaires aux paramètres réels est établi sur la base du raisonnement suivant.

Le signal en sortie de l'unité de mesure 300 répond à la relation:

$$(24) \qquad v'(t) = \frac{V \cdot G \cdot Cx(t)}{Cr} - H,$$

relation dans laquelle

V représente l'amplitude du créneau d'excitation,

G représente le gain du système et

H représente une constante liée essentiellement au dispositif de remise à zéro connecté aux bornes du condensateur de référence.

On déduit de la relation (24) que

$$(25) \quad Cx(t) = Kv'(t) + H' = K\left(v'(t) + \frac{H'}{K}\right) \text{ avec}$$

$$K = Cr/VG \text{ et}$$
$$H = KH$$

Les valeurs K et H' sont mesurées à l'origine grâce à deux condensateurs étalons, puis ces valeurs sont mémorisées.

Les paramètres intermédiaires sont alors transformés en paramètres réels sur la base des relations (17) à (22) en utilisant le coefficient K mémorisé et éventuellement le coefficient a lié au facteur H' par la relation a = H'/K, tel que

$$(26) \quad C(t) = K(y(t) + a).$$

Enfin, à l'étape 276, l'unité de traitement 200 opère un classement des condensateurs.

Ce classement a pour objet de détecter la conformité ou la non conformité des condensateurs aux normes prévues dans un cahier des charges et de suivre par conséquent la qualité de la fabrication. Pour opérer le classement on compare les paramètres réels $C\infty_{mes}$, Csmes et Rmes avec des paramètres idéaux $C\infty$th, Csth et Rth stockés en mémoire lors de l'étape d'initialisation 210.

Si l'écart entre le paramètre réel et le paramètre idéal associé tombe dans l'intervalle mémorisé à l'étape 210 un signal de conformité est émis.

En pratique, on mémorise à l'étape 210 un intervalle de validité ou tolérance en pourcentage ($\pm$x%) de la valeur nominale Cn. Puis l'unité de traitement fait la différence.

$$(27) \quad |C_x\text{mes} - C_x\text{th}| - \frac{x \, Cn}{100}.$$

Si la différence (27) est positive la valeur $C\infty$ est hors des limites fixées et l'unité de traitement 200 émet un signal indiquant que le condensateur Cx est non conforme.

Si par contre, la différence (27) est inférieure ou égale à zéro, la capacité est dans les limites de tolérances demandées et l'unité de traitement 200 émet un signal indiquant la conformité du condensateur en ce qui concerne le paramètre $C\infty$.

L'unité de traitement 200 procède de la même façon pour les paramètres Cs et Ri.

Les résultats des trois procédures de classement relatives aux trois paramètres sont stockés en mémoire.

Les signaux mémorisés peuvent être utilisés pour commander le robot 800 jouant le rôle d'automate de tri.

Le tri peut exiger par exemple que les trois paramètres soient conformes aux normes, ou tenir compte des valeurs de chacun de ces trois paramètres séparément.

Bien entendu, la présente invention n'est aucunement limitée au mode de réalisation précédemment décrit, mais s'étend à toute variante conforme à son esprit.

Ainsi, par exemple, à l'étape 274, on peut éviter la détermination de la pente λ(t) pour l'évaluation des paramètres 1/pi et Ci.

Pour cela, on exploite les séquences suivantes:

$$(28) \quad C_1(t) = C(t) - \frac{t}{Rs}$$

$$(29) \quad \frac{dC_1}{du} = \frac{dC_1}{dt} \cdot \frac{dt}{du} = t \sum_i \frac{1}{Ci\tau i} e^{-t/\tau i}$$

$$(30) \quad \frac{d^2C}{du^2} = -t \sum_i \left[ \frac{1}{Ci\tau i} e^{-t/\tau i} \left( \frac{t}{\tau i} - 1 \right) \right]$$

Si les composantes exponentielles sont séparées on observe des extremum pour $t \simeq \tau i$.

L'algorithme de traitement, à l'étape 274, comprend donc alors tout d'abord l'élimination du terme de «pente finale» t/rs, puis la recherche des minimum de la fonction $\frac{dC_1}{du}$. Ces minimum fournissent les temps $tj = \tau j = RjCj$.

Enfin, en réinjectant les temps tj précités dans la fonction (28) $C_1(t)$, les quantités

$$(31) \quad C_1(tj) = \frac{1-e}{e} Cj + \sum_i^{j-1} Ci$$

sont obtenues.

L'unité de traitement 200 pourra être formée par exemple d'une carte microordinateur du type ECB85 commercialisée par la Société SIEMENS. On rappelle que cette carte comporte un microprocesseur 8085, deux portes entrées/sorties parallèles 8185, une mémoire active RAM statique d'une capacité de 1 octets, un programme moniteur et un circuit type 8279 assurant l'interface avec le clavier 600.

**Revendications**

1. Procédé de test de condensateurs et de matériaux diélectriques, comprenant les étapes consistant:

i) à insérer l'élément à tester (Cx) en série d'une impédance de référence (Cr) dans une chaîne de mesure,

ii) à appliquer à la chaîne de mesure des créneaux répétitifs de stimulation,

iii) à remettre à zéro la tension aux bornes de l'impédance de référence (Cr) au cours de chaque demi-alternance inactive des créneaux de stimulation,

iv) à échantillonner la réponse obtenue aux bornes de l'impédance de référence (Cr) pour chaque créneau de stimulation, à des temps décalés progressivement par rapport aux créneaux de stimulation,

v) à analyser les échantillons pour en déduire les paramètres de l'élément testé selon un modèle de FOSTER.

2. Procédé de test selon la revendication 1, caractérisé par le fait que l'impédance de référence (Cr) est un condensateur.

3. Procédé de test selon la revendication 2, caractérisé par le fait que le condensateur de référence (Cr) possède une capacité supérieure d'environ 1000 fois à celle de l'élément à tester.

4. Procédé de test selon l'une des revendications 1 à 3, caractérisé par le fait que les étapes ii) et iv) d'application de créneaux répétitifs de stimulation et d'échantillonnage sont organisées en une pluralité de salves de créneaux dont les périodes croissent d'une salve à l'autre.

5. Procédé de test selon la revendication 4, caractérisé par le fait que les étapes ii) et iv) comprennent successivement:

— l'application d'une première série de créneaux de stimulation de période constante, accompagnée d'une série d'impulsions d'échantillonnage de période constante et légèrement supérieure à celle des créneaux de stimulation,

— l'application d'une seconde série de créneaux de stimulation de période constante et nettement supérieure à celle des créneaux de stimulation, de la première série accompagnée d'une seconde série d'impulsions d'échantillonnage de période constante et légèrement supérieure à un sous-multiple de celle des créneaux de stimulation,

— l'application d'un créneau de stimulation unique de longue durée accompagnée d'impulsions d'échantillonnage de pas progressivement croissants.

6. Procédé de test selon la revendication 5, caractérisé par le fait que la période des créneaux de stimulation de la première série est de l'ordre de 200 µs, la période des créneaux de stimulation de la seconde série est de l'ordre de 2 ms et le dernier créneau de stimulation présente une durée supérieure à 700 ms.

7. Procédé de test selon l'une des revendications 1 à 6, caractérisé par le fait que pendant au moins une partie de l'étape iv) le décalage temporel entre deux impulsions d'échantillonnage consécutives, par rapport aux créneaux de stimulation est de l'ordre de 0,2 µs.

8. Procédé de test selon l'une des revendications 1 à 7, caractérisé par le fait que le rapport cyclique des créneaux de stimulation est de l'ordre de 1/2.

9. Procédé de test selon l'une des revendications 1 à 8, caractérisé par le fait que l'étape v) d'analyse comprend:

va) la détermination de la pente finale de la réponse comme étant représentative du paramètre 1/RS du modèle de FOSTER et

vb) la détermination de la valeur initiale asymptotique de la réponse comme étant représentative du paramètre Cs du modèle de FOSTER.

10. Procédé de test selon la revendication 9, caractérisé par le fait que l'étape va) consiste à comparer la pente de la réponse à différents instants et à retenir comme pente finale la valeur de pente reconnue identique pour plusieurs instants, l'étape vb) consiste à déterminer la valeur initiale asymptotique en soustrayant de la valeur du $n^{ème}$ échantillon le produit de la pente finale et de l'abscisse du $n^{ème}$ échantillon.

11. Procédé de test selon l'une des revendications 1 à 10, caractérisé par le fait que l'étape v) comprend vc) la détermination de la valeur initiale de la réponse comme étant représentative du paramètre $C\infty$ du modèle de FOSTER.

12. Procédé de test selon la revendication 11, caractérisé par le fait que l'étape vc) consiste à déterminer la valeur initiale de la réponse par extrapolation à partir des deuxième et troisième échantillons en considérant l'origine moyenne to des temps comme étant égale à:

$$to = t_2 - \frac{3\delta T}{2},$$

relation dans laquelle

$t_2$ représente l'instant d'acquisition du second échantillon et

$\delta T$ représente le pas d'échantillonnage.

13. Procédé de test selon l'une des revendications 1 à 12, caractérisé par le fait que l'étape v) comprend

vd) la détermination de l'amplitude des paliers de la courbe de la pente de la réponse comme étant représentative du paramètre 1/Ri du modèle de FOSTER et

ve) la détermination des abscisses des maximum de la dérivée de la pente de la réponse comme étant représentative du temps de relaxation des différentes branches R-C du modèle de FOSTER.

14. Procédé de test selon l'une des revendications 1 à 13, caractérisé par le fait que l'étape v) d'analyse comprend l'étape de conversion des paramètres y(t) déterminés sur la base des échantillons pour obtenir les paramètres de la capacité, selon la loi d'étalonnage linéaire.

C(t) = K y(t) + a, dans lesquels K et a sont des constantes.

15. Procédé de test selon la revendication 14, caractérisé par le fait qu'il comprend l'étape préliminaire consistant:

— à disposer deux condensateurs étalons $Cr_1$ et $Cr_2$ en série dans la chaîne de mesure,

— à détecter la réponse v'(t) à un échelon de stimulation d'amplitude V, telle que

$$v' = \frac{VGCr_1}{Cr_2} - a$$

relation dans laquelle

G représente le gain du système, et

a représente une constante additive due à la remise à zéro de la chaîne de mesure, et par le fait que la phase v) de traitement comprend en outre l'étape consistant

— à corriger les valeurs mesurées y(t) sur la base des coefficients G et a pour obtenir les paramètres de la capacité C(t) selon le modèle de FOSTER répondant à la relation:

C(t) = K(y(t) + a).

16. Procédé de test selon l'une des revendications 1 à 15, caractérisé par le fait qu'il comprend l'étape ultérieure de classement des éléments testés sur la base des paramètres déterminés à l'aide des échantillons.

17. Procédé de test selon l'une des revendications 1 à 16, caractérisé par le fait qu'il comprend en outre les étapes consistant à prélever un échantillon de référence $Y_{nr}$ pour chaque créneau à un instant r constant de ces créneaux et à corriger avant l'étape v) d'analyse chaque échantillon $Y_{nm}$ sur la base de la relation
$Y'_{nm} = Y_{nm} - (Y_{nr} - Y_{1r})$ dans laquelle
$Y_{nr}$ représente l'échantillon de référence pris au $n^{\text{ème}}$ créneau et
$Y_{1r}$ représente l'échantillon de référence pris lors du premier créneau.

18. Procédé de test selon l'une des revendications 1 à 17, caractérisé par le fait qu'à l'origine de chaque processus de test les créneaux de stimulation sont générés avec un retard temporel par rapport aux impulsions de stimulation, et par le fait que seuls les échantillons de valeurs non nulles sont pris en compte.

19. Dispositif de test de condensateurs et de matériaux diélectriques, caractérisé par le fait qu'il comprend:
– une unité de mesure (300) apte à recevoir l'élément à tester (Cx) en série d'une impédance de référence (Cr) dans une chaîne de mesure,
– une base de temps (100) aptes à appliquer à la chaîne de mesure des créneaux répétitifs de stimulation,
– des moyens ($T_2$, $T_3$) adaptés pour remettre à zéro la tension aux bornes de l'impédance de référence (Cr) au cours de chaque demi-alternance inactive des créneaux de stimulation,
– une unité d'échantillonnage (400) sensible à la réponse obtenue aux bornes de l'impédance de référence (Cr) pour chaque créneau de stimulation, et qui échantillonne cette réponse à des temps décalés progressivement par rapport aux créneaux de stimulation,
– une unité de traitement (200) qui analyse les échantillons établis par l'unité d'échantillonnage (400) pour en déduire les paramètres de l'élément testé selon un modèle de FOSTER.

20. Dispositif de test selon la revendication 19, caractérisé par le fait que l'impédance de référence (Cr) est un condensateur.

21. Dispositif de test selon la revendication 20, caractérisé par le fait que le condensateur de référence (Cr) possède une capacité supérieure d'environ 1000 fois à celle de l'élément à tester.

22. Dispositif de test selon l'une des revendications 19 à 21, caractérisé par le fait que l'unité de mesure (300) possède des moyens permettant de modifier l'impédance de référence (Cr) insérée dans la chaîne de mesure.

23. Dispositif de test selon l'une des revendications 19 à 22, caractérisé par le fait que l'unité d'échantillonnage (400) comprend un convertisseur analogique/numérique (450).

24. Dispositif de test selon l'une des revendications 19 à 23, caractérisé par le fait que l'unité de traitement (200) contrôle la base de temps (100) de telle sorte que celle-ci génère plusieurs salves successives de créneaux de stimulation dont les périodes croissent d'une salve à l'autre.

25. Dispositif de test selon l'une des revendications 19 à 24, caractérisé par le fait que la base de temps (100) génère successivement
– une première série de créneaux de stimulation de période constante, accompagnée d'une série d'impulsions d'échantillonnage de période constante et légèrement supérieure à celle des créneaux de stimulation,
– une seconde série de créneaux de stimulation de période constante et nettement supérieure à celle des créneaux de stimulation de la première série accompagnée d'une seconde série d'impulsions d'échantillonnage de période constante et légèrement supérieure à un sous-multiple de celle des créneaux de stimulation, puis
– un créneau de stimulation unique de longue durée accompagnée d'impulsions d'échantillonnage de pas progressivement croissants.

26. Dispositif de test selon la revendication 25, caractérisé par le fait que la période des créneaux de stimulation de la première série est de l'ordre de 200 μs, la période des créneaux de stimulation de la seconde série est de l'ordre de 2 ms et le dernier créneau de stimulation présente une durée supérieure à 700 ms.

27. Dispositif de test selon l'une des revendications 19 à 26, caractérisé par le fait que la base de temps (100) comprend:
– une horloge (101),
– plusieurs diviseurs de fréquence (102, 103, 104, 105, 106, 107; 144) attaqués par l'horloge et déterminant des créneaux de stimulation de périodes respectives,
– des portes de type ET (108, 146) connectées en sortie des diviseurs et validées alternativement par l'unité de traitement (200),
– une porte de type OU (111) dont les entrées sont reliées respectivement en sortie des portes de type ET (108, 146), et à la sortie de laquelle sont disponibles les créneaux de stimulation.

28. Dispositif de test selon la revendication 27, caractérisé par le fait qu'il comprend:
– une seconde série de diviseurs de fréquence (120, 160) attaqués par l'horloge (101) et déterminant des impulsions d'échantillonnage de périodes respectives,
– une seconde série de portes de type ET (130, 172) connectées respectivement en sortie des diviseurs de fréquence (120, 160) de la seconde série et qui sont validées alternativement par l'unité de traitement (200) en synchronisme avec l'une associée des portes ET (108, 146) de la première série, et
– une seconde porte de type OU (131) dont les entrées sont reliées respectivement en sortie des portes ET de la deuxième série à la sortie (135) de laquelle sont disponibles les impulsions d'échantillonnage.

29. Dispositif de test selon l'une des revedications 19 à 28, caractérisé par le fait que la base de temps (100) génère par ailleurs des impulsions d'échantillonnage auxiliaires, à un instant constant de chaque créneau de stimulation, pour le prélèvement d'échantillons de référence.

30. Dispositif de test selon l'une des revendications 19 à 29, caractérisé par le fait que l'unité de mesure (300) comprend entre la chaîne de mesure et l'unité d'échantillonnage (400) successivement un étage de découplage à impédance d'entrée très élevée (OP317) et au moins un étage d'amplification (OP320, OP323).

31. Dispositif de test selon la revendication 30, caractérisé par le fait que la liaison entre la chaîne de mesure (Cx, Cr) et l'étage de découplage (OP317) est blindée.

32. Dispositif de test selon l'une des revendications 19 à 31, caractérisé par le fait que les moyens ($T_2$, $T_3$) de remise à zéro de la tension aux bornes de l'impédance de référence (Cr) possèdent une impédance de sortie très élevée.

33. Dispositif de test selon la revendication 32, caractérisé par le fait que les moyens de remise à zéro comprennent un transistor à effet de champ (T3).

34. Dispositif de test selon l'une des revendications 19 à 33, caractérisé par le fait que l'unité d'échantillonnage comprend en cascade un échantillonneur bloqueur (405), un étage amplificateur (415) et un convertisseur analogique/numérique (450).

35. Dispositif de test selon la revendication 34, caractérisé par le fait que l'échantillonneur bloqueur (405) maintient les informations à sa sortie pendant un temps au moins égal à 25 µs.

36. Dispositif de test selon l'une des revendications 34 et 35, caractérisé par le fait que l'unité d'échantillonnage (400) comprend deux chaînes similaires, parallèles, l'une pour les échantillons de mesure, l'autre pour les échantillons de référence, chaque chaîne comprenant en cascade un échantillonneur bloqueur (405, 425), une étape amplificateur (415, 435) et un convertisseur analogique/numérique (450, 460).

37. Procédé de test selon l'une des revendications 1 à 18, caractérisé par le fait qu'il comprend en outre l'étape consistant à lisser les données à l'aide d'une méthode de moyennage mobile, avant traitement de ces données.

## Claims

1. A method of testing capacitors and dielectric materials, wherein the method comprises the following steps:

i) inserting the item to be tested (Cx) in series with a reference impedance (Cr) in a measuring chain;

ii) applying repetitive stimulating pulses to the measuring chain;

iii) zeroing the voltage at the terminals of the reference impedance (Cr) during each inactive half-cycle of the stimulating pulses;

iv) sampling the response obtained at the terminals of the reference impedance (Cr) for each stimulating pulse at time instants which are progressively shifted relative to the stimulating pulses; and

v) analyzing the samples to deduce the parameters of the element under test in accordance with the Foster model.

2. A test method according to claim 1, wherein the reference impedance (Cr) is a capacitor.

3. A test method according to claim 2, wherein the reference capacitor (Cr) has a capacitance which is about 1000 times great than the capacitance of the item under test.

4. A test method according to one of claims 1 to 3, wherein steps ii) and iv) in which repetitive stimulating pulses are applied and in which sampling takes place are organized as a plurality of bursts of pulses with the periods of the pulses increasing from one burst to the next.

5. A test method according to claim 4, wherein the steps ii) and iv) successively comprise:

applying a first series of stimulating pulses of constant period together with a series of sampling pulses of constant period which period is slightly greater than the period of the stimulating pulses;

applying a second series of stimulating pulses of constant period which period is substantially greater than the period of the stimulating pulses of the first series, together with a second series of sampling pulses of constant period which period is slightly greater than a sub-multiple of the period of the stimulating pulses; and

applying a single stimulating pulse of long duration together with sampling pulses at progressively increasing intervals.

6. A test method according to claim 5, wherein the period of the stimulating pulses of the first series is about 200 µs, the period of the stimulating pulses of the second series is about 2 ms, and the last stimulating pulse having a duration greater than 700 ms.

7. A test method according to one of claims 1 to 6, wherein during at least one portion of step iv) the time slip between two consecutive sampling pulses, relative to the stimulating pulses is about 0.2 µs.

8. A test method according to one of claims 1 to 7, wherein the duty ratio of the stimulating pulses is about 1/2.

9. A test method according to one of claims 1 to 8, wherein analysis step v) comprises:

va) taking the final slope of the response as being representative of the parameter 1/Rs of the Foster model; and

vb) taking the initial asymptotic value of the response as being representative of the parameter Cs of the Foster model.

10. A test method according to claim 9, wherein step va) consists in comparing the slope of the response at different instants and in taking as the value of the final slope the value of the slope at a plurality of successive instants when the value at said successive instants is considered as being equal; and

step vb) consists in determining the initial asymptotic value by subtracting the product of the final slope and the X axis value of the n-th sample from the value of the n-th sample.

11. A test method according to one of claims 1 to 10, wherein step v) includes step vc) of taking the initial value of the response as being representative of the parameter $C\infty$ of the Foster model.

12. A test method according to claim 11, wherein step vc) consists in determining the initial value of the response by extrapolating from the second and third samples and taking the average time origin $t0$ as being equal to

$$t0 = t2 - (3\delta T/2)$$

in which $t2$ represents the instant at which the second sample is acquired; and $\delta T$ represents the sampling interval.

13. A test method according to one of claims 1 to 12, wherein step v) includes

vd) taking the amplitude of the steps in the curve of the slope of the response as being representative of the parameters $1/Ri$ of the Foster model; and

ve) taking the X axis values of the maxima in the derivative of the slope of the response as being representative of the relaxation time of the various R-C branches of the Foster model.

14. A test method according to one of claims 1 to 13, wherein analysis step v) includes the step of converting the parameters $y(t)$ determined on the basis of the samples to obtain parameters relating to capacitance using the linear relationship:

$C(t) = K(y(t)+a)$, in which K and a are constants.

15. A test method according to claim 14, including a preliminary step consisting in:

disposing two reference capacitors Cr1 and Cr2 in series in the measuring chain;

in detecting the response $v'(t)$ to a single stimulation step of amplitude V such that

$$v' = (VGCr1/Cr2) - a$$

in which G represents the gain of the system and a represents an additive constant due to the measuring chain being zeroed; and

wherein the processing step v) further includes a step consisting in correcting the measured values $y(t)$ on the basis of the coefficients G and a in order to obtain capacitance parameters $C(t)$ in accordance with the Foster model and using the equation:

$$C(t) = K(y(t)+a).$$

16. A test method according to one of claims 1 to 15, including a subsequent step of classifying the tested items on the basis of the parameters determined from the samples.

17. A test method according to one of claims 1 to 16, further including the steps of taking a reference sample $Y_{nr}$ for each stimulating pulse at an instant r which is constant relative to said pulses and in correcting each sample $Y_{nm}$ prior to analysis step v) on the basis of the relationship

$$Y'_{nm} = Y_{nm} - (Y_{nr}-Y_{1r})$$ in which

$Y_{nr}$ represents the reference sample taken during the n-th stimulating pulse; and $Y_{1r}$ represents the reference sample taken during the first stimulating pulse.

18. A test method according to one of claims 1 to 17, wherein the stimulating pulses are generated from the beginning of each test process with a time delay relative to the sampling pulses, and wherein only those samples having non-zero values are taken into consideration.

19. Apparatus for testing capacitors and dielectric materials, said apparatus comprising:

a measuring unit (300) suitable for receiving an item (Cx) to be tested in series with a reference impedance (Cr) in a measuring chain;

a clock (100) suitable for applying repetitive stimulating pulses to the measuring chain;

means (T2, T3) adapted to reset the voltage at the terminals of the reference impedance (Cr) to zero during each inactive half-cycle of the stimulating pulses;

a sampling unit (400) sensitive to the response obtained at the terminals of the reference impedance (Cr) during each stimulating pulse, and which samples said response at instants which are progressively shifted relative to the stimulating pulses; and

a processing unit (200) which analyzes the samples taken by the sampling unit (400) to deduce the parameters of the tested item in accordance with the Foster model.

20. Test apparatus according to claim 19, wherein the reference impedance (Cr) is a capacitor.

21. Test apparatus according to claim 20, wherein the reference capacitor (Cr) has a capacitance which is about 1000 times greater than the capacitance of the item under test.

22. Test apparatus according to one of claims 19 to 21, wherein the measuring unit (300) includes means enabling the reference impedance (Cr) inserted in the measuring chain to be modified.

23. Test apparatus according to one of claims 19 to 22, wherein the sampling unit (400) includes an analog-to-digital converter (450).

24. Test apparatus according to one of claims 19 to 23, wherein the processing unit (200) controls the clock (100) in such a manner that the clock generates a plurality of successive bursts of stimulating pulses having periods which increase from one burst to the next.

25. Test apparatus according to one of claims 19 to 24, wherein the clock (100) successively generates:

a first burst of stimulating pulses of constant period together with a series of sampling pulses of constant period which period is slightly greater than the period of the stimulating pulses;

a second burst of stimulating pulses of constant period which period is substantially greater than the period of the stimulating pulses of the first burst, together with a second burst of sampling pulses of constant period which period is slightly greater than a sub-multiple of the period of the stimulating pulses; and then

a single stimulating pulse of long duration together with sampling pulses at progressively increasing intervals.

26. Test apparatus according to claim 25, wherein the period of the stimulating pulses of the first burst is about 200 µs, the period of the stimulating pulses of the second burst is about 2 ms, and the last stimulating pulse has a duration of greater than 700 ms.

27. Test apparatus according to one of claims 19 to 26, wherein the clock (100) comprises:

a master oscillator (101);

a plurality of frequency dividers (102, 103, 104, 105, 106, 107; 114) driven by the master oscillator and generating stimulating pulses of various periods;

AND gates (108, 146) connected to the outputs of the dividers and selectively enabled by the processing unit (200);

an OR gate (111) whose inputs are connected to respective outputs from said AND gates (108, 146) and whose output provided said stimulating pulses.

28. Test apparatus according to claim 27, further including:

a second series of frequency dividers (120, 160) driven by the master oscillator (101) and generating sampling pulses at various periods;

a second series of AND gates (130, 172) connected to respective outputs from the second series of frequency dividers (120, 160) and selectively enabled by the processing unit (200) synchronously with an associated one of the AND gates (108, 146) of the first series of AND gates; and

a second OR gate (131) whose inputs are connected to the outputs of the second series of AND gates and whose output (135) provides the sampling pulses.

29. Test apparatus according to one of claims 19 to 28, wherein the clock (100) also generates auxiliary sampling pulses at a constant instant in each stimulating pulse, for the purpose of taking reference samples.

30. Test apparatus according to one of claims 19 to 29, wherein the measuring unit (300) includes, in succession between the measuring chain and the sampling unit (400), a decoupling stage (OP317) having very high input impedance and at least one amplifier stage (OP3230, OP323).

31. Test apparatus according to claim 30, wherein the connection between the measuring chain (Cx, Cl) and the decoupling stage (OP317) is screened.

32. Test apparatus according to one of claims 19 to 31, wherein the means (T2, T3) for resetting the voltage at the terminals of the reference impedance (Cr) to zero have very high output impedance.

33. Test apparatus according to claim 32, wherein the means for resetting the voltage to zero include a field effect transistor (T3).

34. Test apparatus according to one of claims 19 to 33, wherein the sampling unit includes in cascade: a sample-and-hold circuit (405), an amplifier stage (415), and an analog-to-digital converter (450).

35. Test apparatus according to claim 34, wherein the sample-and-hold circuit (405) holds data at its output for a period of not less than 25 µs.

36. Test apparatus according to claim 34 or 35, wherein the sampling unit (400) includes two similar parallel chains, one for measurement samples and the other for reference samples, each of said chains comprising in cascade: a sample-and-hold circuit (405, 425), an amplifier stage (415, 435), and an analog-to-digital converter (450, 460).

37. A test method according to one of claims 1 to 18, further including a step prior to processing the measurement data, in which the measurement data is smooth using a moving mean method.

## Patentansprüche

1. Verfahren zur Prüfung von Kondensatoren und dielektrischen Materialien, das folgende Etappen umfaßt:

i) Serienschaltung des Prüflings (Cx) mit einem Referenzwiderstand (Cr) in einer Meßkette,

ii) Beaufschlagung der Meßkette mit rechteckigen Erregungsimpulsen,

iii) Nullstellung der elektrischen Spannung an den Klemmen des Referenzwiderstandes (Cr) im Laufe jeder einzelnen inaktiven Halbperiode der rechteckigen Erregungsimpulse,

iv) Abtastung der an den Klemmen des Referenzwiderstandes (Cr) für die bei jedem rechteckigen Erregungsimpuls erzielten Reaktion in zeitlich verschobener Reihenfolge zu den rechteckigen Erregungsimpulsen,

v) Auswertung der Abtastungen, um daraus nach einem FOSTER'schen Modell die Parameter des Prüflings abzuleiten.

2. Prüfverfahren nach Anspruch 1, dadurch gekennzeichnet, daß der Referenzwiderstand (Cr) ein Kondensator ist.

3. Prüfverfahren nach Anspruch 2, dadurch gekennzeichnet, daß der Referenzkondensator (Cr) eine Kapazität besitzt, die etwa 1000 mal größer ist, als diejenige des Prüflings.

4. Prüfverfahren nach einem der Ansprüche 1–3, dadurch gekennzeichnet, daß die Etappen ii) und iv) der Beaufschlagung der rechteckigen Erregungsimpulse und die Abtastung in einer Vielzahl von Erregungsstößen, deren Periodizität von einem Stoß zum anderen anwachsen.

5. Prüfverfahren nach Anspruch 4, dadurch gekennzeichnet, daß die Etappen ii) und iv) nacheinander folgendes umfassen:

– Beaufschlagung einer ersten Serie von Erregungsimpulsen konstanter Periodizität, begleitet von einer Serie von Abtastimpulsen konstanter Periodizität, die leicht über derjenigen der Erregerimpulse liegt,

– Beaufschlagung einer zweiten Serie von Erregerimpulsen konstanter Periodizität, die jedoch deutlich höher ist, als diejenige der Erregerimpulse der ersten Serie, begleitet von einer zweiten Serie von Abtastimpulsen konstanter Periodizität, die leicht über einem Subvielfachen derjenigen der Erregerimpulse liegt,

– Beaufschlagung eines einzigen Erregerimpulses fortgesetzter Dauer, begleitet von Abtastimpulsen ständig ansteigender Stärke.

6. Prüfverfahren nach Anspruch 5, dadurch gekennzeichnet, daß die Periodizität der Erregerimpulse der ersten Serie eine Größenordnung von 200 µs hat, während die Periodizität der Erregerimpulse der zweiten Serie eine Größenordnung von 2 ms und der letzte Erregerimpuls eine Dauer von mehr als 700 ms hat.

7. Prüfverfahren nach einem der Ansprüche 1–6, dadurch gekennzeichnet, daß mindestens während eines Teils der Etappe iv) die zeitliche Verschiebung zwischen zwei aufeinanderfolgenden Abtastimpulsen im Vergleich zu den Erregerimpulsen eine Größenordnung von 0,2 µs hat.

8. Prüfverfahren nach einem der Ansprüche 1–7, dadurch gekennzeichnet, daß das zyklische Verhältnis der Erregerimpulse eine Größenordnung von 1/2 hat.

9. Prüfverfahren nach einem der Ansprüche 1–8, dadurch gekennzeichnet, daß die Analyseetappe v) folgendes umfaßt:

va) Bestimmung der endgültigen ansteigenden Kurve der Reaktion als repräsentativer Wert für den Parameter 1/RS des FOSTER'schen Modells, und

vb) Bestimmung des asymptotischen Anfangswertes der Reaktion als repräsentativen Wert für den Parameter Cs des FOSTER'schen Modells.

10. Prüfverfahren nach Anspruch 9, dadurch gekennzeichnet, daß die Etappe va) darin besteht, die Kurve der Reaktion zu verschiedenen Zeitpunkten zu vergleichen und als endgültige Kurve den Kurvenwert festzulegen, der für mehrere Zeitpunkte als identisch erkannt wurde, während die Etappe vb) darin besteht, den anfänglichen asymptotischen Wert dadurch zu bestimmen, daß man von dem Wert der x-ten Abtastung das Produkt der endgültigen Kurve und der Abszisse der x-ten Abtastung von der x-ten Abtastung abzieht.

11. Prüfverfahren nach einem der Ansprüche 1–10, dadurch gekennzeichnet, daß die Etappe v) vc) die Bestimmung des anfänglichen Wertes der Reaktion als repräsentativen Wert für den Parameter $C_x$ des FOSTER'schen Modells umfaßt.

12. Prüfverfahren nach Anspruch 11, dadurch gekennzeichnet, daß die Etappe vc) darin besteht, den anfänglichen Reaktionswert durch Extrapolation der zweiten und dritten Abtastwerte zu bestimmen, wobei angenommen wird, daß der Ausgangspunkt to der Zeiten folgender Gleichung entspricht:

$$to = t_2 - \frac{3\delta T}{2}$$

darin bedeuten:

$t_2$ den Augenblick der Erfassung des zweiten Abtastwertes und

$\delta T$ den Abtastschritt.

13. Prüfverfahren nach einem der Ansprüche 1 bis 12, dadurch gekennzeichnet, daß die Etappe v) folgendes umfaßt:

vd) die Bestimmung der Amplitude der Stufen der ansteigenden Kurve der Reaktion als repräsentativen Wert für den Parameter 1/Ri des FOSTER'schen Modells, und

ve) die Bestimmung der Abszissen der maximalen Ablenkung der Reaktionskurve als repräsentativen Wert für die zeitliche Verzögerung der verschiedenen R-C Streckenabschnitte des FOSTER'schen Modells.

14. Prüfverfahren nach einem der Ansprüche 1 bis 13, dadurch gekennzeichnet, daß die Analyseetappe v) die Umwandlung der Parameter y(t) umfaßt, die auf der Basis der Abtastwerte bestimmt wurden, um die Kapazitätsparameter nach dem Gesetz der linearen Eichung zu erhalten:

$C(t) = K\, y(t) + a$, worin K und a konstante Werte sind.

15. Prüfverfahren nach Anspruch 14, dadurch gekennzeichnet, daß es eine Voretappe enthält, die folgendes umfaßt:

– Serienschaltung von zwei Eichkondensatoren $Cr_1$ und $Cr_2$ in der Meßkette,

– Feststellung der Reaktion v'(t) in einem Erregungsgrad mit einer Amplitude V nach folgender Gleichung:

$$v' = \frac{VGCr_1}{Cr_2} - a$$

darin bedeuten:

G die Systemverstärkung, und

a eine summierende Konstante aufgrund der Rückstellung auf Null der Meßkette, und dadurch, daß die Auswertungsphase v) weiterhin eine Etappe umfaßt, die darin besteht, daß

– die gemessenen Werte y(t) auf der Basis der Koeffizienten korrigiert werden, um die Parameter der Kapazität C(t) nach dem FOSTER'schen Modell nach folgender Gleichung zu erzielen:

$$C(t) = K(y(t) + a).$$

16. Prüfverfahren nach einem der Ansprüche 1 bis 15, dadurch gekennzeichnet, daß es die Etappe enthält, in der die getesteten Elemente auf der Basis der Parameter eingestuft werden, die mit Hilfe der Abtastergebnisse bestimmt wurden.

17. Prüfverfahren nach einem der Ansprüche 1 bis 16, dadurch gekennzeichnet, daß es außerdem die Etappen enthält, die darin bestehen, eine Referenzabtastung $Y_{nr}$ für jeden Rechteckimpuls zu einem konstanten Zeitpunkt r dieser Rechteckimpulse zu messen und vor der Analyseetappe v) jede Abtastung auf der Basis folgender Gleichung zu korrigieren:

$$Y'_{nm} = Y_{nm} - (Y_{nr} - Y_{1r})$$

darin bedeuten:

$Y_{nr}$ die am x-ten Rechteckimpuls durchgeführte Referenzabtastung, und

$Y_{1r}$ die am ersten Rechteckimpuls durchgeführte Referenzabtastung.

18. Prüfverfahren nach einem der Ansprüche 1 bis 17, dadurch gekennzeichnet, daß zu Anfang jeden Prüfverfahrens die rechteckigen Erregerimpulse im Vergleich zu den Erregerimpulsen mit zeitlicher Verzögerung verursacht werden, und dadurch, daß nur die Abtastungen berücksichtigt werden, deren Werte nicht null sind.

19. Vorrichtung zur Prüfung von Kondensatoren und dielektrischen Materialien, dadurch gekennzeichnet, daß sie folgendes aufweist:
– eine Meßeinheit (300), die geeignet ist, den Prüfling (Cx) in Serie geschaltet mit einem Bezugswiderstand (Cr) in einer Meßkette aufzunehmen,
– eine Zeitablenkung (100), die geeignet ist, die Meßkette mit wiederholenden Erregerimpulsen zu beaufschlagen,
– Mittel (T$_2$, T$_3$), die geeignet sind, die Spannung an den Klemmen des Bezugswiderstandes (Cr) im Laufe jeder inaktiven Halbperiode der rechteckigen Erregerimpulse auf Null zu stellen,
– eine Abtasteinheit (400) empfindlich auf die Reaktion an den Klemmen des Bezugswiderstandes (Cr) bei jedem Erregerimpuls, die diese Reaktion zu Zeitpunkten abtastet, die fortschreitend im Vergleich zu den Erregerimpulsen verschoben sind,
– eine Auswertungseinheit (200), die die durch die Abtasteinheit (400) durchgeführten Abtastungen analysiert, um daraus die Parameter des Prüflings abzuleiten, der nach einem FOSTER'schen Modell getestet wurde.

20. Prüfvorrichtung nach Anspruch 19, dadurch gekennzeichnet, daß der Bezugswiderstand (Cr) ein Kondensator ist.

21. Prüfvorrichtung nach Anspruch 20, dadurch gekennzeichnet, daß der Referenzkondensator (Cr) eine Kapazität besitzt, die etwa 1000 mal größer ist, als diejenige des Prüflings.

22. Prüfvorrichtung nach einem der Ansprüche 19 bis 21, dadurch gekennzeichnet, daß die Meßeinheit (300) Mittel aufweist, die es erlauben, den in die Meßkette eingeschalteten Referenzwiderstand (Cr) zu verändern.

23. Prüfvorrichtung nach einem der Ansprüche 19 bis 22, dadurch gekennzeichnet, daß die Abtasteinheit (400) einen analog-digitalen Umwandler (450) enthält.

24. Prüfvorrichtung nach einem der Ansprüche 19 bis 23, dadurch gekennzeichnet, daß die Auswertungseinheit (200) die Zeitablenkungsbasis (100) so kontrolliert, daß diese mehrere aufeinanderfolgende Salven von Erregerimpulsen verursacht, deren Perioden von einer Salve zur anderen ansteigen.

25. Prüfvorrichtung nach einem der Ansprüche 19 bis 24, dadurch gekennzeichnet, daß die Zeitablenkungsbasis (100) nacheinander folgendes auslöst:

– eine erste Serie von Erregerimpulsen mit konstanter Periode, begleitet von einer Serie von Abtastimpulsen konstanter Periode, die leicht über derjenigen der Erregerimpulse liegt,
– eine zweite Periode von Erregerimpulsen mit konstanter Periode, die deutlich über derjenigen der Erregerimpulse der ersten Serie liegt, begleitet von einer zweiten Serie von Abtastimpulsen konstanter Periodizität, die leicht über einem Subvielfachen derjenigen der Erregerimpulse liegt, und dann

– einen rechteckigen Erregerimpuls langer Dauer, begleitet von fortschreitend ansteigenden Abtastimpulsen.

26. Prüfvorrichtung nach Anspruch 25, dadurch gekennzeichnet, daß die Periodizität der Erregerimpulse der ersten Serie eine Größenordnung von 200 µs hat, während die Periodizität der Erregerimpulse der zweiten Serie 2 ms beträgt und der letzte Erregerimpuls eine Dauer von über 700 ms hat.

27. Prüfvorrichtung nach einem der Ansprüche 19 bis 26, dadurch gekennzeichnet, daß die Zeitablenkungsbasis (100) folgendes umfaßt:
– einen Zeitgeber (101),
– mehrere Frequenzteiler (102, 103, 104, 105, 106, 107; 144), die von dem Zeitgeber geschaltet werden und rechteckige Erregerimpulse jeweiliger Perioden bestimmen,
– Und-Gatter (108, 146), die am Ausgang der Frequenzteiler angeschlossen sind und abwechselnd von der Rechnereinheit (200) validiert werden,
– ein Oder-Gatter (111), dessen Eingänge jeweils am Ausgang der Und-Gatter (108, 146) angeschlossen sind und an dessen Ausgang die rechteckigen Erregerimpulse verfügbar sind.

28. Prüfvorrichtung nach Anspruch 27, dadurch gekennzeichnet, daß sie folgendes enthält:
– eine zweite Serie von Frequenzteilern (120, 160), die von dem Zeitgeber (101) geschaltet werden und Abtastimpulse jeweiliger Perioden bestimmen,
– eine zweite Serie von Und-Gattern (130, 172), die jeweils am Ausgang der Frequenzteiler (120, 160) der zweiten Serie angeschlossen sind und die abwechselnd von der Rechnereinheit (200) synchron mit einem zugeordneten Und-Gatter (108, 146) der ersten Serie validiert werden, und
– ein zweites Oder-Gatter (131), dessen Eingänge jeweils am Ausgang der Und-Gatter der zweiten Serie angeschlossen sind und an dessen Ausgang (135) die Abtastimpulse verfügbar sind.

29. Prüfvorrichtung nach einem der Ansprüche 19 bis 28, dadurch gekennzeichnet, daß die Zeitbasis (100) außerdem an einem konstanten Zeitpunkt jedes rechteckigen Erregerimpulses Hilfsabtastimpulse verursacht, damit Referenzabtastungen gemessen werden können.

30. Prüfvorrichtung nach einem der Ansprüche 19 bis 29, dadurch gekennzeichnet, daß die Meßeinheit (300) zwischen der Meßkette und der Abtasteinheit (400) nacheinander eine Entkoppelungsstufe mit sehr hohem Eingangswiderstand (OP317) und mindestens eine Verstärkerstufe (OP320, OP323) aufweist.

31. Prüfvorrichtung nach Anspruch 30, dadurch gekennzeichnet, daß die Verbindung zwischen der Meßkette (Cx, Cr) und der Entkoppelungsstufe (OP317) abgeschirmt ist.

32. Prüfvorrichtung nach einem der Ansprüche 19 bis 31, dadurch gekennzeichnet, daß die Mittel (T$_2$, T$_3$) für die Nullstellung der Spannung an den Klemmen des Referenzwiderstandes (Cr) einen sehr hohen Ausgangswiderstand aufweisen.

33. Prüfvorrichtung nach Anspruch 32, dadurch gekennzeichnet, daß die Mittel für die Nullstellung einen Feldeffekt-Transistor (T3) aufweisen.

34. Prüfvorrichtung nach einem der Ansprüche 19 bis 33, dadurch gekennzeichnet, daß die Abtasteinheit kaskadenförmig einen Tastspeicherverstärker (405), eine Verstärkerstufe (415) und einen Analog-Digital-Umsetzer (450) aufweist.

35. Prüfvorrichtung nach Anspruch 34, dadurch gekennzeichnet, daß der Tastspeicherverstärker (405) die Informationen an seinem Ausgang über einen Zeitraum von mindestens 25 µs aufrechterhält.

36. Prüfvorrichtung nach einem der Ansprüche 34 und 35, dadurch gekennzeichnet, daß die Abtasteinheit (400) zwei gleiche parallele Ketten aufweist, die eine für die Meßabtastungen, die andere für die Referenzabtastungen, wobei jede dieser Ketten kaskadenförmig einen Tastspeicherverstärker (405, 425), eine Verstärkerstufe (415, 435) und einen Analog-Digital-Umsetzer (450, 460) aufweist.

37. Prüfverfahren nach einem der Ansprüche 1 bis 18, dadurch gekennzeichnet, daß es außerdem eine Etappe enthält, die darin besteht, daß die Daten mit Hilfe einer mobilen Durchschnittsglättungsmethode abgeglichen werden, bevor diese Daten verarbeitet werden.

FIG.1

FIG.7

FIG_2

FIG_3

FIG_4

FIG_5

FIG_6a

Cycle de test

| 1ère salve | 2ème Salve | |
|---|---|---|
| • 500 creneaux stimulus période 200 µs | • 10 creneaux stimulus période 2 ms | • 1 creneau 800ms |
| • Echantillonnage 200, 2 µs | • Echantillonnage 202 µs | • Echantillonnage en temps réel |

FIG_6b    1ère Salve

FIG_6c    2ème Salve

29

FIG_8

FIG_9

FIG.10

FIG. 11

FIG. 12

210

221

RAZ BASE DE TEMPS 100

220

222

INITIALISATION REGISTRES

223

VALIDATION SORTIE 201
INVALIDATION SORTIES 202 à 204

LIRE $\overline{DR}$ — 224

231

NON $\overline{DR} = 1$ — 225

OUI

LIRE $\overline{DR}$ — 226

INCREMENT
ADRESSE
N

NON $\overline{DR} = 0$ — 227

OUI

228

CORRECTION
$Y_{n,m} = Y_{n,m} - (Y_{nr} - Y_{1r})$

229

STOCKAGE
ADRESSE N

230

NOMBRE
DONNEES
MEMORISEES
= P

NON

OUI

FIG_13

240

ACQUISITION
$2^{eme}$ GAMME

37

FIG_14

FIG_15

39